# EUROPEAN PATENT SPECIFICATION

(11) **EP 2 882 766 B1**
(45) Date of publication and mention of the grant of the patent: **27.11.2019**
(21) Application number: 13828031.8
(22) Date of filing: 06.08.2013
(51) Int. Cl.: C07F 15/00, H01L 51/00

(54) **TRANSITION METAL COMPLEXES WITH CARBENE LIGANDS AND USE THEREOF IN OLEDS**
ÜBERGANGSMETALLKOMPLEXE MIT CARBENLIGANDEN UND IHRE VERWENDUNG FÜR OLEDS
COMPLEXES DE MÉTAUX DE TRANSITION AVEC DES LIGANDS DE TYPE CARBÈNE ET LEUR UTILISATION DANS LES OLED

(30) Priority: 09.08.2012 EP 12179876; 09.08.2012 US 201261681163 P
(43) Date of publication of application: 17.06.2015
(73) Proprietor: UDC Ireland Limited, Ballycoolin, Dublin 15 (IE)
(72) Inventor: STRAßNER, Thomas, 01156 Dresden (DE); TRONNIER, Alexander, 01087 Dresden (DE); METZ, Stefan, 68165 Mannheim (DE); HEINEMEYER, Ute, 67433 Neustadt (DE)
(74) Representative: Maiwald Patent- und Rechtsanwaltsgesellschaft mbH
(86) International application number: PCT/IB2013/056434
(87) International publication number: WO 2014/024131

(56) References cited:
- WO-A1-2007/088093
- WO-A1-2011/073149
- WO-A2-2005/113704
- WO-A2-2006/056418
- US-A1- 2005 260 445
- US-A1- 2005 260 448
- US-A1- 2006 287 544
- US-A1- 2009 018 330

## Description

The present invention relates to palladium and platinum complexes with one bidentate carbene ligand, to OLEDs (Organic Light-Emitting Diodes) which comprise such complexes, to a device selected from the group consisting of illuminating elements, stationary visual display units and mobile visual display units comprising such an OLED, to the use of such a metal-carbene complex in OLEDs, for example as emitter, matrix material, charge transport material and/or charge or exciton blocker.

Organic light-emitting diodes (OLEDs) exploit the propensity of materials to emit light when they are excited by electrical current. OLEDs are of particular interest as an alternative to cathode ray tubes and liquid-crystal displays for production of flat visual display units. Owing to the very compact design and the intrinsically low power consumption, devices comprising OLEDs are suitable especially for mobile applications, for example for applications in cellphones, smartphones, digital cameras, mp3 players, laptops, etc. In addition, white OLEDs give great advantages over the illumination technologies known to date, especially a particularly high efficiency.

The prior art proposes numerous materials which emit light on excitation by electrical current.

US2005/0260448 relates to luminescent metal complexes having carbene ligands.

US2006/0024522 discloses the use of transition metal complexes comprising at least one carbene ligand in OLEDs. According to US2006/0024522, these complexes include heteroleptic platinum complexes with a carbene ligand. However, no examples and advantages of complexes of this type have been described.

WO2006/018292 discloses the use of transition metal-carbene complexes having at least one unsymmetrically substituted carbene ligand in organic light-emitting diodes. The complexes are embedded in a polymer matrix.

WO2007/088093 discloses the synthesis of metal carbene complexes, including one specific example for a platinum complex:

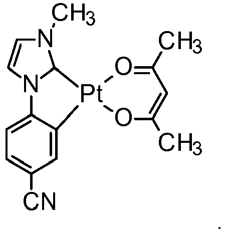

JP 2008/147398 and JP2008/147424 describe complexes with carbene ligands used in OLEDs.

US2010/0270915 discloses heteroleptic Pt complexes with a substituted acetylacetonato ligand. When used as emissive materials those compounds show a strong dependency of the color on the doping concentration resulting from strong aggregation even at for OLEDs relevant doping concentrations.

WO2011/073149 discloses Pt complexes having carbene ligands and acetylacetonato derived ligands. However, the carbene ligands of WO2011073149 differ from those in this application. Unlike the complexes of the current invention those complexes are not designed for a deep blue photoluminescence (see example EM15 reported in WO2011/073149: 2% EM15 in PMMA; λₘₐₓ = 484 nm).

US provisional application 61/496646 (european patent application number 11169895.7) discloses the use transition metal complexes containing carbene ligands in OLEDs. Besides Ir also Pt is described to be a suitable metal center for those compounds. However, no explicit synthetic example is reported in US provisional application 61/496646.

WO 2006/056418 A2 relates to the use of transition metal-carbene complexes in organic light-emitting diodes (OLEDs), to a light-emitting layer, to a blocking layer for electrons or excitons, or to a blocking layer for holes, each comprising these transition metal-carbene complexes.

Even though there are already known Pd and Pt carbene complexes which are suitable for use in OLEDs, especially as light-emitting substances, it is desirable to provide more stable and/or more efficient compounds which are usable in industry.

It is therefore an object of the present invention to provide palladium and platinum complexes which are suitable for use in organic electronic components. More particularly, the palladium and platinum complexes shall be suitable for use in OLEDs as emitters, matrix material, charge transport material, or charge blockers. The complexes shall be particularly suitable for color-tuning of the electroluminescence, which enables, for example, the production of full-color displays and white OLEDs. It is a further object of the present invention to provide corresponding complexes which can be used as a mixture with a host compound (matrix material) or as a pure layer as a light-emitting layer in OLEDs. More particularly, it is desirable to provide Pd and Pt transition metal complexes which exhibit a spectrum of properties improved over known Pd or Pt complexes, for example improved efficiencies, improved CIE color coordinates, decreased color dependency on the emitter doping concentration and/or improved lifetime/stability.

Surprisingly, it was found that these objects are achieved in accordance with the invention by metal-carbene complex of the general formula 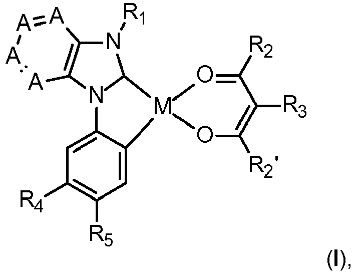 wherein
M is Pd or Pt,
R₁ is a linear or branched alkyl radical optionally interrupted by at least one heteroatom, optionally bearing at least one functional group selected from the group consisting of C₁-C₂₀-atkyt, C₁-C₂₀-alkoxy, halogen, C₁-C₂₀-haloalkyl, and C₆-C₃₀-aryl, and having 1 to 20 carbon atoms, a cycloalkyl radical optionally interrupted by at least one heteroatom, and having 3 to 20 carbon atoms and wherein the cycloalkyl radical is optionally substituted with at least one group selected from the group consisting of C₁-C₂₀-alkyl, C₁-C₂₀-alkoxy, halogen, C₁-C₂₀-haloalkyl, and C₆-C₃₀-aryl, an aryl radical having 6 to 30 carbon atoms and wherein the aryl radical is optionally substituted with at least one group selected from the group consisting of C₁-C₂₀-alkyl, C₆-C₃₀-aryl and a group with donor or acceptor action, a heteroaryl radical having a total of 5 to 18 carbon atoms and/or heteroatoms selected from N, O and S and wherein the heteroaryl radical is optionally substituted with at least one group selected from the group consisting of C₁-C₂₀-alkyl, C₆-C₃₀-aryl and a group with donor or acceptor action,
R₂ and R₂' are independently of each other a linear or branched alkyl radical having 1 to 6 carbons atoms, a cycloalkyl radical having 3 to 20 carbon atoms optionally substituted with at least one group selected from the group consisting of C₁-C₂₀-alkyl, C₁-C₂₀-alkoxy, halogen, C₁-C₂₀-haloalkyl, and C₆-C₃₀-aryl, an aryl radical having 6 to 20 carbon atoms optionally substituted with at least one group selected from the group consisting of C₁-C₂₀-alkyl, C₆-C₃₀-aryl and a group with donor or acceptor action, or a heteroaryl radical having a total of 5 to 18 carbon atoms and/or heteroatoms selected from N, O and S optionally substituted with at least one group selected from the group consisting of C₁-C₂₀-alkyl, C₆-C₃₀-aryl and a group with donor or acceptor action,
R₃ is hydrogen, a linear or branched alkyl radical having 1 to 6 carbon atoms, or an aryl radical having 6 to 20 carbon atoms optionally substituted with at least one group selected from the group consisting of C₁-C₂₀-alkyl, C₆-C₃₀-aryl and a group with donor or acceptor action,
R₄ and R₅ are independently of each other hydrogen, a linear or branched alkyl radical optionally interrupted by at least one heteroatom, and having 1 to 6 carbon atoms, cycloalkyl radical optionally interrupted by at least one heteroatom, and having 3 to 12 carbon atoms and wherein the cycloalkyl radical is optionally substituted with at least one group selected from the group consisting of C₁-C₂₀-alkyl, C₁-C₂₀-alkoxy, halogen, C₁-C₂₀-haloalkyl, and C₆-C₃₀-aryl, an aryl radical optionally interrupted by at least one heteroatom, and having 6 to 15 carbon atoms and wherein the aryl radical is optionally substituted with at least one group selected from the group consisting of C₁-C₂₀-alkyl, C₆-C₃₀-aryl and a group with donor or acceptor action, a heteroaryl radical having a total of 5 to 18 carbon atoms and/or heteroatoms selected from N, O and S and wherein the heteroaryl radical is optionally substituted with at least one group selected from the group consisting of C₁-C₂₀-alkyl, C₆-C₃₀-aryl and a group with donor or acceptor action, group with donor or acceptor action,
A is independently in each occurrence CR₆ or N, with the proviso that at least 3 A's are CR₆;
each R₆ is independently of each other hydrogen, a linear or branched alkyl radical optionally interrupted by at least one heteroatom, and having 1 to 20 carbon atoms, a cycloalkyl radical optionally interrupted by at least one heteroatom, and having 3 to 20 carbon atoms and wherein the cycloalkyl radical is optionally substituted with at least one group selected from the group consisting of C₁-C₂₀-alkyl, C₁-C₂₀-alkoxy, halogen, C₁-C₂₀-haloalkyl, and C₆-C₃₀-aryl, an aryl radical optionally interrupted by at least one heteroatom, and having 6 to 30 carbon atoms and wherein the aryl radical is optionally substituted with at least one group selected from the group consisting of C₁-C₂₀-alkyl, C₆-C₃₀-aryl and a group with donor or acceptor action, a heteroaryl radical having a total of 5 to 18 carbon atoms and/or heteroatoms selected from N, O and S and wherein the heteroaryl radical is optionally substituted with at least one group selected from the group consisting of C₁-C₂₀-alkyl, C₆-C₃₀-aryl and a group with donor or acceptor action, group with donor or acceptor action, whereby the group with donor or acceptor action is selected from the group consisting of: C₁- to C₂₀-alkoxy; C₆-C₃₀-aryloxy; SiR⁶⁴R⁶⁵R⁶⁶, where R⁶⁴, R⁶⁵ and R⁶⁶ are each independently alkyl or phenyl; halogen radicals; halogenated C₁-C₂₀-alkyl radicals; amino; OH; and -C(O)OC₁-C₄-alkyl.

The inventive metal-carbene complexes can be used in electronic devices, especially OLEDs (Organic Light-Emitting Diodes), for example, as emitter, matrix material, charge transport material and/or charge or exciton blocker.

The inventive metal-carbene complexes are generally notable for light emission in a wide range of the electromagnetic spectrum having a low concentration dependency of the emission spectrum.

The inventive metal-carbene complexes are therefore suitable with particular preference as emitter material in OLEDs.

In a preferred embodiment the present invention is directed to metal-carbene complexes of the general formula 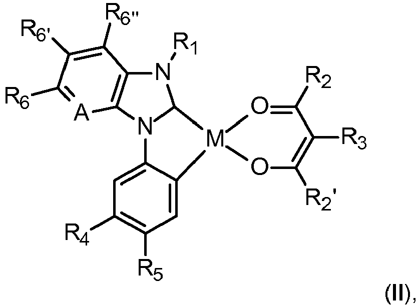 wherein R₆ and R_{6"} have independently of each other the meaning of R₆ and M, R₁, R₂, R₂', R₃, R₄, R₅, R₆ and A are each as defined above.

In said embodiment metal-carbene complexes of the general formula 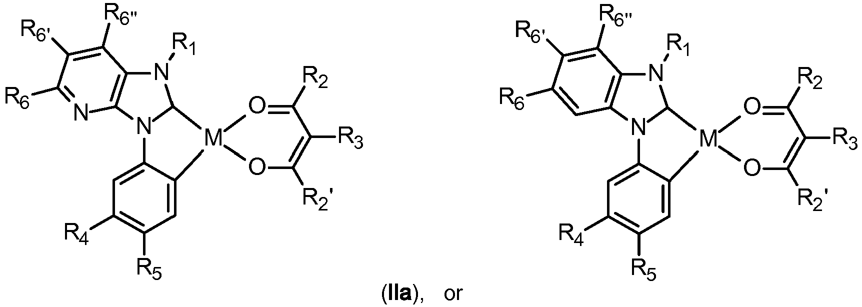 (**IIb**) are more preferred, wherein M, R₁, R₂, R₂', R₃, R₄, R₅, R₆, R_{6'}, R_{6"} and A are each as defined above.

M is Pd or Pt, preferably Pt.

A is especially CH, or N; very especially CH.

R₁ is preferably a linear or branched alkyl radical having 1 to 6 carbons atoms, very especially methyl, ethyl, isopropyl, tert-butyl; a substituted; or unsubstituted aryl radical having 6 to 15 carbon atoms, especially unsubstituted phenyl, 2,6-dialkylphenyl, or 2,4,6-trialkylphenyl. More preferred R₁ is C₁-C₆alkyl, phenyl, 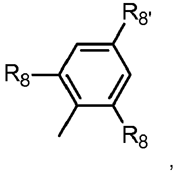 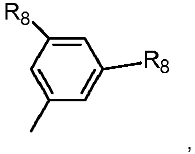 wherein R₈ is C₁-C₄alkyl and R_{8'} is H, or C₁-C₄alkyl; 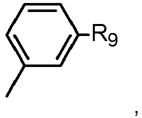 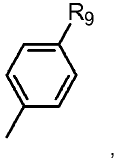 wherein R₉ is H, CF₃, C₁-C₆alkyl, F, or Si(CH₃)₃. Most preferred R¹ is unsubstituted phenyl, 2,6-diC₁-C₆alkylphenyl, or 2,4,6-triC₁-C₆alkylphenyl.

Preferably R₂ and R₂' are independently of each other a linear or branched alkyl radical having 1 to 6 carbon atoms, a substituted or unsubstituted aryl radical having 6 to 20 carbon atoms, preferably unsubstituted phenyl, 2,6-dialkylphenyl or 2,4,6-trialkylphenyl; substituted or unsubstituted heteroaryl radical having a total of 5 to 18 carbon atoms and/or heteroatoms. In a preferred embodiment of the present invention at least one of R₂ and R₂', especially R₂ and R₂' are phenyl, or a group of formula 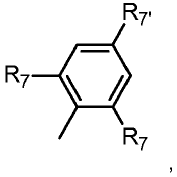 wherein R₇ is C₁-C₆alkyl and R_{7'} is hydrogen, or C₁-C₆alkyl.

R₃ is preferably hydrogen, or a linear or branched alkyl radical having 1 to 6 carbon atoms, more preferably hydrogen. Examples of suitable compounds HL, 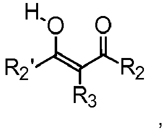 from which the ligands L, 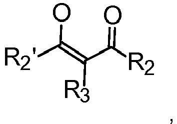 are derived, include 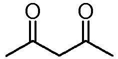 (2,4-pentanedione [acac]), 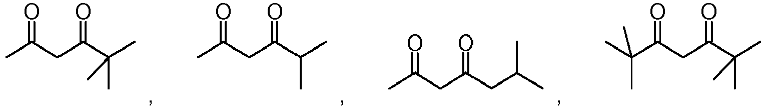 (2,2,6,6-tetramethyl-3,5-heptanedione [TMH]), 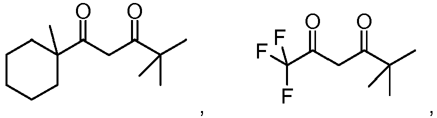 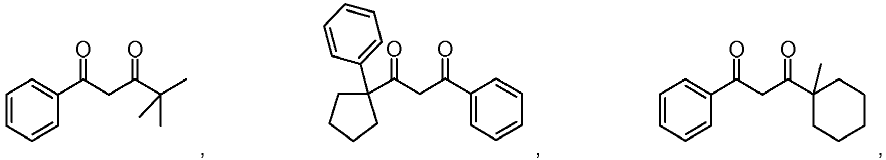 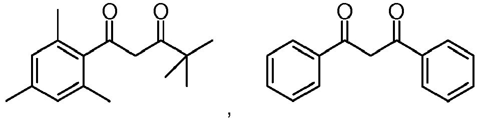 (1,3-diphenyl-1,3-propanedione [DI]), 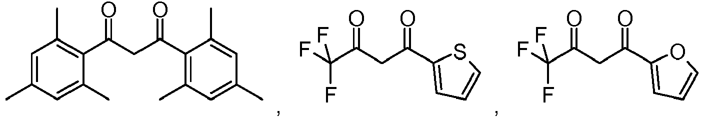 (4,4,4-trifluoro-1-(2-thienyl)-1,3-butanedione [TTFA]), 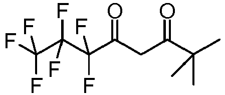 (7,7-dimethyl-1,1,1,2,2,3,3-heptafluoro-4,6-octanedione [FOD]), 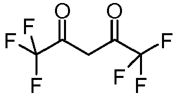 (1,1,1,5,5,5-hexafluoro-2,4-pentanedione [F6acac]),

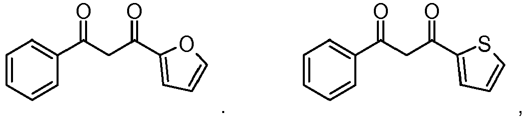

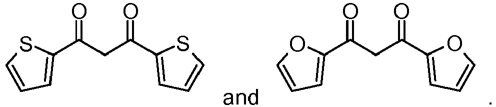

Preferably, R₄ and R₅ are each independently hydrogen, a linear or branched alkyl radical having 1 to 6 carbon atoms, substituted or unsubstituted aryl radical having 6 to 15 carbon atoms, or a group with donor or acceptor action, selected from halogen radicals, preferably F and Cl, more preferably F; CF₃, CN and SiMe₃. Most preferred, R₄ is H, CF₃, C₁-C₆alkyl, F, or Si(CH₃)₃. Most preferred, R₅ is H, CF₃, C₁-C₆alkyl, F, or Si(CH₃)₃.

R₆ and R_{6'} are especially hydrogen, or C₁-C₆alkyl, very especially H. R_{6"} is preferably hydrogen.

In a particularly preferred embodiment the present invention is directed to metal-carbene complexes of formula 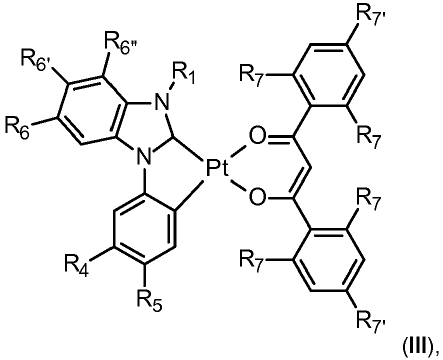 wherein
R₁ is a linear or branched alkyl radical having 1 to 6 carbons atoms, preferably methyl, ethyl, isopropyl, tert-butyl; a substituted, or unsubstituted aryl radical having 6 to 15 carbon atoms, preferably unsubstituted phenyl, 2,6-dialkylphenyl, or 2,4,6-trialkylphenyl,
R₄ and R₅ are each independently hydrogen, a linear or branched alkyl radical having 1 to 6 carbon atoms, substituted or unsubstituted aryl radical having 6 to 15 carbon atoms, or a group with donor or acceptor action, selected from halogen radicals, preferably F and Cl, more preferably F; CF₃, CN and SiMe₃,
R₆ and R_{6'} are each independently hydrogen, a linear or branched alkyl radical, preferably H, methyl, ethyl, isopropyl, or tert-butyl;
R_{6"} is hydrogen;
R₇ is a linear or branched alkyl radical having 1 to 6 carbons atoms, a substituted or unsubstituted cycloalkyl radical having 3 to 6 carbon atoms, preferably methyl, ethyl, isopropyl, tert-butyl; and
R_{7'} is H, or has the meaning of R₇.

R₁ is preferably a linear or branched alkyl radical having 1 to 6 carbons atoms, very especially methyl, ethyl, isopropyl, tert-butyl; a substituted; or unsubstituted aryl radical having 6 to 15 carbon atoms, very especially unsubstituted phenyl, 2,6-dialkylphenyl, or 2,4,6-trialkylphenyl.

Preferably, R₆ and R_{6'} are hydrogen, or C₁-C₆alkyl; and R_{6"} is hydrogen.

Examples of C₁-C₆alkyl are methyl, ethyl, propyl, isopropyl, butyl, isobutyl, isopentyl, sec-butyl, tert-butyl, pentyl, neopentyl and hexyl.

In a preferred embodiment the present invention is directed to compounds of formula 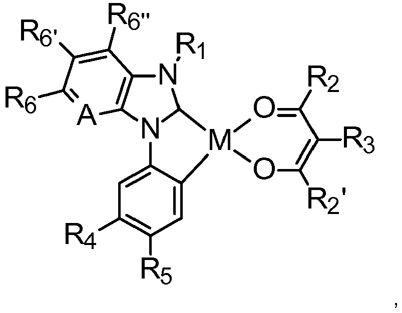 wherein
M is Pd or Pt, preferably Pt;
A is CH, or N;
R₁ is C₁-C₄alkyl, phenyl, 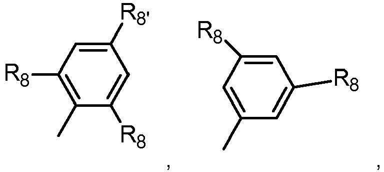 wherein R₈ is C₁-C₄alkyl and R_{8'} is H, or C₁-C₄alkyl; 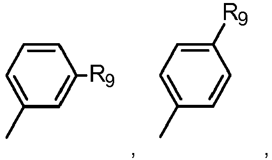 wherein R₉ is H, CF₃, C₁-C₄alkyl, F, or Si(CH₃)₃;
R₂ and R_{2'} are C₁-C₆alkyl, phenyl, or a group of formula 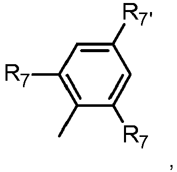 wherein R₇ is C₁-C₄alkyl and R_{7'} is H, or C₁-C₄alkyl;
R₃ is hydrogen;
R₄ is H, CF₃, C₁-C₄alkyl, F, or Si(CH₃)₃;
R₅ is H, CF₃, C₁-C₄alkyl, F, or Si(CH₃)₃;
R₆ and R_{6'} are hydrogen; and
R_{6"} is hydrogen.
C₁-C₄alkyl is methyl, ethyl, propyl, isopropyl, butyl, isobutyl, isopentyl, sec-butyl, or tert-butyl, especially methyl, ethyl, isopropyl, or tert-butyl.

Examples of suitable compounds are shown in the table below:

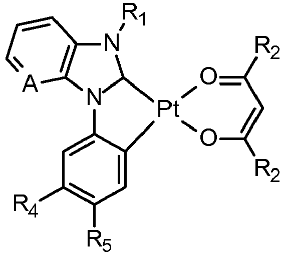

| **Cpd.** | **R₁** | **R₂** | **R₄** | **R₅** | **A** |
|---|---|---|---|---|---|
| **D-1** | Me | Me | H | H | CH |
| **D-2** | Me | Me | tBu | H | CH |
| **D-3** | Me | Me | SiMe₃ | H | CH |
| **D-4** | Me | Me | CF₃ | H | CH |
| **D-5** | Me | Me | F | H | CH |
| **D-6** | Me | Me | H | tBu | CH |
| **D-7** | Me | Me | H | SiMe₃ | CH |
| **D-8** | Me | Me | H | CF₃ | CH |
| **D-9** | Me | Me | H | F | CH |
| **D-10** | Me | Me | H | CN | CH |
| **D-11** | Me | tBu | H | H | CH |
| **D-12** | Me | tBu | tBu | H | CH |
| **D-13** | Me | tBu | SiMe₃ | H | CH |
| **D-14** | Me | tBu | CF₃ | H | CH |
| **D-15** | Me | tBu | F | H | CH |
| **D-16** | Me | tBu | H | tBu | CH |
| **D-17** | Me | tBu | H | SiMe₃ | CH |
| **D-18** | Me | tBu | H | CF₃ | CH |
| **D-19** | Me | tBu | H | F | CH |
| **D-20** | Me | tBu | H | CN | CH |
| **D-21** | Me | Ph | H | H | CH |
| **D-22** | Me | Ph | tBu | H | CH |
| **D-23** | Me | Ph | SiMe₃ | H | CH |
| **D-24** | Me | Ph | CF₃ | H | CH |
| **D-25** | Me | Ph | F | H | CH |
| **D-26** | Me | Ph | H | tBu | CH |
| **D-27** | Me | Ph | H | SiMe₃ | CH |
| **D-28** | Me | Ph | H | CF₃ | CH |
| **D-29** | Me | Ph | H | F | CH |
| **D-30** | Me | Ph | H | CN | CH |
| **D-31** | Me | DIPP | H | H | CH |
| **D-32** | Me | DIPP | tBu | H | CH |
| **D-33** | Me | DIPP | SiMe₃ | H | CH |
| **D-34** | Me | DIPP | CF₃ | H | CH |
| **D-35** | Me | DIPP | F | H | CH |
| **D-36** | Me | DIPP | H | tBu | CH |
| **D-37** | Me | DIPP | H | SiMe₃ | CH |
| **D-38** | Me | DIPP | H | CF₃ | CH |
| **D-39** | Me | DIPP | H | F | CH |
| **D-40** | Me | DIPP | H | CN | CH |
| **D-41** | Me | TMP | H | H | CH |
| **D-42** | Me | TMP | tBu | H | CH |
| **D-43** | Me | TMP | SiMe₃ | H | CH |
| **D-44** | Me | TMP | CF₃ | H | CH |
| **D-45** | Me | TMP | F | H | CH |
| **D-46** | Me | TMP | H | tBu | CH |
| **D-47** | Me | TMP | H | SiMe₃ | CH |
| **D-48** | Me | TMP | H | CF₃ | CH |
| **D-49** | Me | TMP | H | F | CH |
| **D-50** | Me | TMP | H | CN | CH |
| **D-51** | iPr | Me | H | H | CH |
| **D-52** | iPr | Me | tBu | H | CH |
| **D-53** | iPr | Me | SiMe₃ | H | CH |
| **D-55** | iPr | Me | CF₃ | H | CH |
| **D-56** | iPr | Me | F | H | CH |
| **D-57** | iPr | Me | H | tBu | CH |
| **D-58** | iPr | Me | H | SiMe₃ | CH |
| **D-59** | iPr | Me | H | CF₃ | CH |
| **D-60** | iPr | Me | H | F | CH |
| **D-61** | iPr | Me | H | CN | CH |
| **D-62** | iPr | tBu | H | H | CH |
| **D-63** | iPr | tBu | tBu | H | CH |
| **D-64** | iPr | tBu | SiMe₃ | H | CH |
| **D-65** | iPr | tBu | CF₃ | H | CH |
| **D-66** | iPr | tBu | F | H | CH |
| **D-67** | iPr | tBu | H | tBu | CH |
| **D-68** | iPr | tBu | H | SiMe₃ | CH |
| **D-69** | iPr | tBu | H | CF₃ | CH |
| **D-70** | iPr | tBu | H | F | CH |
| **D-71** | iPr | tBu | H | CN | CH |
| **D-72** | iPr | Ph | H | H | CH |
| **D-73** | iPr | Ph | tBu | H | CH |
| **D-74** | iPr | Ph | SiMe₃ | H | CH |
| **D-75** | iPr | Ph | CF₃ | H | CH |
| **D-76** | iPr | Ph | F | H | CH |
| **D-77** | iPr | Ph | H | tBu | CH |
| **D-78** | iPr | Ph | H | SiMe₃ | CH |
| **D-79** | iPr | Ph | H | CF₃ | CH |
| **D-80** | iPr | Ph | H | F | CH |
| **D-81** | iPr | Ph | H | CN | CH |
| **D-82** | iPr | DIPP | H | H | CH |
| **D-83** | iPr | DIPP | tBu | H | CH |
| **D-84** | iPr | DIPP | SiMe₃ | H | CH |
| **D-85** | iPr | DIPP | CF₃ | H | CH |
| **D-86** | iPr | DIPP | F | H | CH |
| **D-87** | iPr | DIPP | H | tBu | CH |
| **D-88** | iPr | DIPP | H | SiMe₃ | CH |
| **D-89** | iPr | DIPP | H | CF₃ | CH |
| **D-90** | iPr | DIPP | H | F | CH |
| **D-91** | iPr | DIPP | H | CN | CH |
| **D-92** | iPr | TMP | H | H | CH |
| **D-93** | iPr | TMP | tBu | H | CH |
| **D-94** | iPr | TMP | SiMe₃ | H | CH |
| **D-95** | iPr | TMP | CF₃ | H | CH |
| **D-96** | iPr | TMP | F | H | CH |
| **D-97** | iPr | TMP | H | tBu | CH |
| **D-98** | iPr | TMP | H | SiMe₃ | CH |
| **D-99** | iPr | TMP | H | CF₃ | CH |
| **D-100** | iPr | TMP | H | F | CH |
| **D-101** | iPr | TMP | H | CN | CH |
| **D-102** | Ph | Me | H | H | CH |
| **D-103** | 3-tBu-Ph | Me | tBu | H | CH |
| **D-104** | 3-(Me₃Si)Ph | Me | SiMe₃ | H | CH |
| **D-105** | 3-(F₃C)Ph | Me | CF₃ | H | CH |
| **D-106** | 3-F-Ph | Me | F | H | CH |
| **D-107** | 4-tBu-Ph | Me | H | tBu | CH |
| **D-108** | 4-(Me₃Si)Ph | Me | H | SiMe₃ | CH |
| **D-109** | 4-(F₃C)Ph | Me | H | CF₃ | CH |
| **D-110** | 4-F-Ph | Me | H | F | CH |
| **D-111** | 4-NC-Ph | Me | H | CN | CH |
| **D-112** | Ph | tBu | H | H | CH |
| **D-113** | 3-tBu-Ph | tBu | tBu | H | CH |
| **D-114** | 3-(Me₃Si)Ph | tBu | SiMe₃ | H | CH |
| **D-115** | 3-(F₃C)Ph | tBu | CF₃ | H | CH |
| **D-116** | 3-F-Ph | tBu | F | H | CH |
| **D-117** | 4-tBu-Ph | tBu | H | tBu | CH |
| **D-118** | 4-(Me₃Si)Ph | tBu | H | SiMe₃ | CH |
| **D-119** | 4-(F₃C)Ph | tBu | H | CF₃ | CH |
| **D-120** | 4-F-Ph | tBu | H | F | CH |
| **D-121** | 4-NC-Ph | tBu | H | CN | CH |
| **D-122** | Ph | Ph | H | H | CH |
| **D-123** | 3-tBu-Ph | Ph | tBu | H | CH |
| **D-124** | 3-(Me₃Si)Ph | Ph | SiMe₃ | H | CH |
| **D-125** | 3-(F₃C)Ph | Ph | CF₃ | H | CH |
| **D-126** | 3-F-Ph | Ph | F | H | CH |
| **D-127** | 4-tBu-Ph | Ph | H | tBu | CH |
| **D-128** | 4-(Me₃Si)Ph | Ph | H | SiMe₃ | CH |
| **D-129** | 4-(F₃C)Ph | Ph | H | CF₃ | CH |
| **D-130** | 4-F-Ph | Ph | H | F | CH |
| **D-131** | 4-NC-Ph | Ph | H | CN | CH |
| **D-132** | Ph | DIPP | H | H | CH |
| **D-133** | 3-tBu-Ph | DIPP | tBu | H | CH |
| **D-134** | 3-(Me₃Si)Ph | DIPP | SiMe₃ | H | CH |
| **D-135** | 3-(F₃C)Ph | DIPP | CF₃ | H | CH |
| **D-136** | 3-F-Ph | DIPP | F | H | CH |
| **D-137** | 4-tBu-Ph | DIPP | H | tBu | CH |
| **D-138** | 4-(Me₃Si)Ph | DIPP | H | SiMe₃ | CH |
| **D-139** | 4-(F₃C)Ph | DIPP | H | CF₃ | CH |
| **D-140** | 4-F-Ph | DIPP | H | F | CH |
| **D-141** | 4-NC-Ph | DIPP | H | CN | CH |
| **D-142** | Ph | TMP | H | H | CH |
| **D-143** | 3-tBu-Ph | TMP | tBu | H | CH |
| **D-144** | 3-(Me₃Si)Ph | TMP | SiMe₃ | H | CH |
| **D-145** | 3-(F₃C)Ph | TMP | CF₃ | H | CH |
| **D-146** | 3-F-Ph | TMP | F | H | CH |
| **D-147** | 4-tBu-Ph | TMP | H | tBu | CH |
| **D-148** | 4-(Me₃Si)Ph | TMP | H | SiMe₃ | CH |
| **D-149** | 4-(F₃C)Ph | TMP | H | CF₃ | CH |
| **D-150** | 4-F-Ph | TMP | H | F | CH |
| **D-151** | 4-NC-Ph | TMP | H | CN | CH |
| **D-152** | TMP | Me | H | H | CH |
| **D-153** | TMP | Me | tBu | H | CH |
| **D-154** | TMP | Me | SiMe₃ | H | CH |
| **D-155** | TMP | Me | CF₃ | H | CH |
| **D-156** | TMP | Me | F | H | CH |
| **D-157** | TMP | Me | H | tBu | CH |
| **D-158** | TMP | Me | H | SiMe₃ | CH |
| **D-159** | TMP | Me | H | CF₃ | CH |
| **D-160** | TMP | Me | H | F | CH |
| **D-161** | TMP | Me | H | CN | CH |
| **D-162** | TMP | tBu | H | H | CH |
| **D-163** | TMP | tBu | tBu | H | CH |
| **D-164** | TMP | tBu | SiMe₃ | H | CH |
| **D-165** | TMP | tBu | CF₃ | H | CH |
| **D-166** | TMP | tBu | F | H | CH |
| **D-167** | TMP | tBu | H | tBu | CH |
| **D-168** | TMP | tBu | H | SiMe₃ | CH |
| **D-169** | TMP | tBu | H | CF₃ | CH |
| **D-170** | TMP | tBu | H | F | CH |
| **D-171** | TMP | tBu | H | CN | CH |
| **D-172** | TMP | Ph | H | H | CH |
| **D-173** | TMP | Ph | tBu | H | CH |
| **D-174** | TMP | Ph | SiMe₃ | H | CH |
| **D-175** | TMP | Ph | CF₃ | H | CH |
| **D-176** | TMP | Ph | F | H | CH |
| **D-177** | TMP | Ph | H | tBu | CH |
| **D-178** | TMP | Ph | H | SiMe₃ | CH |
| **D-179** | TMP | Ph | H | CF₃ | CH |
| **D-180** | TMP | Ph | H | F | CH |
| **D-181** | TMP | Ph | H | CN | CH |
| **D-182** | TMP | DIPP | H | H | CH |
| **D-183** | TMP | DIPP | tBu | H | CH |
| **D-184** | TMP | DIPP | SiMe₃ | H | CH |
| **D-185** | TMP | DIPP | CF₃ | H | CH |
| **D-186** | TMP | DIPP | F | H | CH |
| **D-187** | TMP | DIPP | H | tBu | CH |
| **D-188** | TMP | DIPP | H | SiMe₃ | CH |
| **D-189** | TMP | DIPP | H | CF₃ | CH |
| **D-190** | TMP | DIPP | H | F | CH |
| **D-191** | TMP | DIPP | H | CN | CH |
| **D-192** | TMP | TMP | H | H | CH |
| **D-193** | TMP | TMP | tBu | H | CH |
| **D-194** | TMP | TMP | SiMe₃ | H | CH |
| **D-195** | TMP | TMP | CF₃ | H | CH |
| **D-196** | TMP | TMP | F | H | CH |
| **D-197** | TMP | TMP | H | tBu | CH |
| **D-198** | TMP | TMP | H | SiMe₃ | CH |
| **D-199** | TMP | TMP | H | CF₃ | CH |
| **D-200** | TMP | TMP | H | F | CH |
| **D-201** | TMP | TMP | H | CN | CH |
| **D-202** | DMP | Me | H | H | CH |
| **D-203** | DMP | Me | tBu | H | CH |
| **D-204** | DMP | Me | SiMe₃ | H | CH |
| **D-205** | DMP | Me | CF₃ | H | CH |
| **D-206** | DMP | Me | F | H | CH |
| **D-207** | DMP | Me | H | tBu | CH |
| **D-208** | DMP | Me | H | SiMe₃ | CH |
| **D-209** | DMP | Me | H | CF₃ | CH |
| **D-210** | DMP | Me | H | F | CH |
| **D-211** | DMP | Me | H | CN | CH |
| **D-212** | DMP | tBu | H | H | CH |
| **D-213** | DMP | tBu | tBu | H | CH |
| **D-214** | DMP | tBu | SiMe₃ | H | CH |
| **D-215** | DMP | tBu | CF₃ | H | CH |
| **D-216** | DMP | tBu | F | H | CH |
| **D-217** | DMP | tBu | H | tBu | CH |
| **D-218** | DMP | tBu | H | SiMe₃ | CH |
| **D-219** | DMP | tBu | H | CF₃ | CH |
| **D-220** | DMP | tBu | H | F | CH |
| **D-221** | DMP | tBu | H | CN | CH |
| **D-222** | DMP | Ph | H | H | CH |
| **D-223** | DMP | Ph | tBu | H | CH |
| **D-224** | DMP | Ph | SiMe₃ | H | CH |
| **D-225** | DMP | Ph | CF₃ | H | CH |
| **D-226** | DMP | Ph | F | H | CH |
| **D-227** | DMP | Ph | H | tBu | CH |
| **D-228** | DMP | Ph | H | SiMe₃ | CH |
| **D-229** | DMP | Ph | H | CF₃ | CH |
| **D-230** | DMP | Ph | H | F | CH |
| **D-231** | DMP | Ph | H | CN | CH |
| **D-232** | DMP | DIPP | H | H | CH |
| **D-233** | DMP | DIPP | tBu | H | CH |
| **D-234** | DMP | DIPP | SiMe₃ | H | CH |
| **D-235** | DMP | DIPP | CF₃ | H | CH |
| **D-236** | DMP | DIPP | F | H | CH |
| **D-237** | DMP | DIPP | H | tBu | CH |
| **D-238** | DMP | DIPP | H | SiMe₃ | CH |
| **D-239** | DMP | DIPP | H | CF₃ | CH |
| **D-240** | DMP | DIPP | H | F | CH |
| **D-241** | DMP | DIPP | H | CN | CH |
| **D-242** | DMP | TMP | H | H | CH |
| **D-243** | DMP | TMP | tBu | H | CH |
| **D-244** | DMP | TMP | SiMe₃ | H | CH |
| **D-245** | DMP | TMP | CF₃ | H | CH |
| **D-246** | DMP | TMP | F | H | CH |
| **D-247** | DMP | TMP | H | tBu | CH |
| **D-248** | DMP | TMP | H | SiMe₃ | CH |
| **D-249** | DMP | TMP | H | CF₃ | CH |
| **D-250** | DMP | TMP | H | F | CH |
| **D-251** | DMP | TMP | H | CN | CH |
| **D-252** | DIPP | Me | H | H | CH |
| **D-253** | DIPP | Me | tBu | H | CH |
| **D-254** | DIPP | Me | SiMe₃ | H | CH |
| **D-255** | DIPP | Me | CF₃ | H | CH |
| **D-256** | DIPP | Me | F | H | CH |
| **D-257** | DIPP | Me | H | tBu | CH |
| **D-258** | DIPP | Me | H | SiMe₃ | CH |
| **D-259** | DIPP | Me | H | CF₃ | CH |
| **D-260** | DIPP | Me | H | F | CH |
| **D-261** | DIPP | Me | H | CN | CH |
| **D-262** | DIPP | tBu | H | H | CH |
| **D-263** | DIPP | tBu | tBu | H | CH |
| **D-264** | DIPP | tBu | SiMe₃ | H | CH |
| **D-265** | DIPP | tBu | CF₃ | H | CH |
| **D-266** | DIPP | tBu | F | H | CH |
| **D-267** | DIPP | tBu | H | tBu | CH |
| **D-268** | DIPP | tBu | H | SiMe₃ | CH |
| **D-269** | DIPP | tBu | H | CF₃ | CH |
| **D-270** | DIPP | tBu | H | F | CH |
| **D-271** | DIPP | tBu | H | CN | CH |
| **D-272** | DIPP | Ph | H | H | CH |
| **D-273** | DIPP | Ph | tBu | H | CH |
| **D-274** | DIPP | Ph | SiMe₃ | H | CH |
| **D-275** | DIPP | Ph | CF₃ | H | CH |
| **D-276** | DIPP | Ph | F | H | CH |
| **D-277** | DIPP | Ph | H | tBu | CH |
| **D-278** | DIPP | Ph | H | SiMe₃ | CH |
| **D-279** | DIPP | Ph | H | CF₃ | CH |
| **D-280** | DIPP | Ph | H | F | CH |
| **D-281** | DIPP | Ph | H | CN | CH |
| **D-282** | DIPP | DIPP | H | H | CH |
| **D-283** | DIPP | DIPP | tBu | H | CH |
| **D-284** | DIPP | DIPP | SiMe₃ | H | CH |
| **D-285** | DIPP | DIPP | CF₃ | H | CH |
| **D-286** | DIPP | DIPP | F | H | CH |
| **D-287** | DIPP | DIPP | H | tBu | CH |
| **D-288** | DIPP | DIPP | H | SiMe₃ | CH |
| **D-289** | DIPP | DIPP | H | CF₃ | CH |
| **D-290** | DIPP | DIPP | H | F | CH |
| **D-291** | DIPP | DIPP | H | CN | CH |
| **D-292** | DIPP | TMP | H | H | CH |
| **D-293** | DIPP | TMP | tBu | H | CH |
| **D-294** | DIPP | TMP | SiMe₃ | H | CH |
| **D-295** | DIPP | TMP | CF₃ | H | CH |
| **D-296** | DIPP | TMP | F | H | CH |
| **D-297** | DIPP | TMP | H | tBu | CH |
| **D-298** | DIPP | TMP | H | SiMe₃ | CH |
| **D-299** | DIPP | TMP | H | CF₃ | CH |
| **D-300** | DIPP | TMP | H | F | CH |
| **D-301** | DIPP | TMP | H | CN | CH |
| **E-1** | **Me** | **Me** | **H** | **H** | **N** |
| **E-2** | Me | Me | tBu | H | N |
| **E-3** | Me | Me | SiMe₃ | H | N |
| **E-4** | Me | Me | CF₃ | H | N |
| **E-5** | Me | Me | F | H | N |
| **E-6** | Me | Me | H | tBu | N |
| **E-7** | Me | Me | H | SiMe₃ | N |
| **E-8** | Me | Me | H | CF₃ | N |
| **E-9** | Me | Me | H | F | N |
| **E-10** | Me | Me | H | CN | N |
| **E-11** | Me | tBu | H | H | N |
| **E-12** | Me | tBu | tBu | H | N |
| **E-13** | Me | tBu | SiMe₃ | H | N |
| **E-14** | Me | tBu | CF₃ | H | N |
| **E-15** | Me | tBu | F | H | N |
| **E-16** | Me | tBu | H | tBu | N |
| **E-17** | Me | tBu | H | SiMe₃ | N |
| **E-18** | Me | tBu | H | CF₃ | N |
| **E-19** | Me | tBu | H | F | N |
| **E-20** | Me | tBu | H | CN | N |
| **E-21** | Me | Ph | H | H | N |
| **E-22** | Me | Ph | tBu | H | N |
| **E-23** | Me | Ph | SiMe₃ | H | N |
| **E-24** | Me | Ph | CF₃ | H | N |
| **E-25** | Me | Ph | F | H | N |
| **E-26** | Me | Ph | H | tBu | N |
| **E-27** | Me | Ph | H | SiMe₃ | N |
| **E-28** | Me | Ph | H | CF₃ | N |
| **E-29** | Me | Ph | H | F | N |
| **E-30** | Me | Ph | H | CN | N |
| **E-31** | Me | DIPP | H | H | N |
| **E-32** | Me | DIPP | tBu | H | N |
| **E-33** | Me | DIPP | SiMe₃ | H | N |
| **E-34** | Me | DIPP | CF₃ | H | N |
| **E-35** | Me | DIPP | F | H | N |
| **E-36** | Me | DIPP | H | tBu | N |
| **E-37** | Me | DIPP | H | SiMe₃ | N |
| **E-38** | Me | DIPP | H | CF₃ | N |
| **E-39** | Me | DIPP | H | F | N |
| **E-40** | Me | DIPP | H | CN | N |
| **E-41** | Me | TMP | H | H | N |
| **E-42** | Me | TMP | tBu | H | N |
| **E-43** | Me | TMP | SiMe₃ | H | N |
| **E-44** | Me | TMP | CF₃ | H | N |
| **E-45** | Me | TMP | F | H | N |
| **E-46** | Me | TMP | H | tBu | N |
| **E-47** | Me | TMP | H | SiMe₃ | N |
| **E-48** | Me | TMP | H | CF₃ | N |
| **E-49** | Me | TMP | H | F | N |
| **E-50** | Me | TMP | H | CN | N |
| **E-51** | iPr | Me | H | H | N |
| **E-52** | iPr | Me | tBu | H | N |
| **E-53** | iPr | Me | SiMe₃ | H | N |
| **E-55** | iPr | Me | CF₃ | H | N |
| **E-56** | iPr | Me | F | H | N |
| **E-57** | iPr | Me | H | tBu | N |
| **E-58** | iPr | Me | H | SiMe₃ | N |
| **E-59** | iPr | Me | H | CF₃ | N |
| **E-60** | iPr | Me | H | F | N |
| **E-61** | iPr | Me | H | CN | N |
| **E-62** | iPr | tBu | H | H | N |
| **E-63** | iPr | tBu | tBu | H | N |
| **E-64** | iPr | tBu | SiMe₃ | H | N |
| **E-65** | iPr | tBu | CF₃ | H | N |
| **E-66** | iPr | tBu | F | H | N |
| **E-67** | iPr | tBu | H | tBu | N |
| **E-68** | iPr | tBu | H | SiMe₃ | N |
| **E-69** | iPr | tBu | H | CF₃ | N |
| **E-70** | iPr | tBu | H | F | N |
| **E-71** | iPr | tBu | H | CN | N |
| **E-72** | iPr | Ph | H | H | N |
| **E-73** | iPr | Ph | tBu | H | N |
| **E-74** | iPr | Ph | SiMe₃ | H | N |
| **E-75** | iPr | Ph | CF₃ | H | N |
| **E-76** | iPr | Ph | F | H | N |
| **E-77** | iPr | Ph | H | tBu | N |
| **E-78** | iPr | Ph | H | SiMe₃ | N |
| **E-79** | iPr | Ph | H | CF₃ | N |
| **E-80** | iPr | Ph | H | F | N |
| **E-81** | iPr | Ph | H | CN | N |
| **E-82** | iPr | DIPP | H | H | N |
| **E-83** | iPr | DIPP | tBu | H | N |
| **E-84** | iPr | DIPP | SiMe₃ | H | N |
| **E-85** | iPr | DIPP | CF₃ | H | N |
| **E-86** | iPr | DIPP | F | H | N |
| **E-87** | iPr | DIPP | H | tBu | N |
| **E-88** | iPr | DIPP | H | SiMe₃ | N |
| **E-89** | iPr | DIPP | H | CF₃ | N |
| **E-90** | iPr | DIPP | H | F | N |
| **E-91** | iPr | DIPP | H | CN | N |
| **E-92** | iPr | TMP | H | H | N |
| **E-93** | iPr | TMP | tBu | H | N |
| **E-94** | iPr | TMP | SiMe₃ | H | N |
| **E-95** | iPr | TMP | CF₃ | H | N |
| **E-96** | iPr | TMP | F | H | N |
| **E-97** | iPr | TMP | H | tBu | N |
| **E-98** | iPr | TMP | H | SiMe₃ | N |
| **E-99** | iPr | TMP | H | CF₃ | N |
| **E-100** | iPr | TMP | H | F | N |
| **E-101** | iPr | TMP | H | CN | N |
| **E-102** | Ph | Me | H | H | N |
| **E-103** | 3-tBu-Ph | Me | tBu | H | N |
| **E-104** | 3-(Me₃Si)Ph | Me | SiMe₃ | H | N |
| **E-105** | 3-(F₃C)Ph | Me | CF₃ | H | N |
| **E-106** | 3-F-Ph | Me | F | H | N |
| **E-107** | 4-tBu-Ph | Me | H | tBu | N |
| **E-108** | 4-(Me₃Si)Ph | Me | H | SiMe₃ | N |
| **E-109** | 4-(F₃C)Ph | Me | H | CF₃ | N |
| **E-110** | 4-F-Ph | Me | H | F | N |
| **E-111** | 4-NC-Ph | Me | H | CN | N |
| **E-112** | Ph | tBu | H | H | N |
| **E-113** | 3-tBu-Ph | tBu | tBu | H | N |
| **E-114** | 3-(Me₃Si)Ph | tBu | SiMe₃ | H | N |
| **E-115** | 3-(F₃C)Ph | tBu | CF₃ | H | N |
| **E-116** | 3-F-Ph | tBu | F | H | N |
| **E-117** | 4-tBu-Ph | tBu | H | tBu | N |
| **E-118** | 4-(Me₃Si)Ph | tBu | H | SiMe₃ | N |
| **E-119** | 4-(F₃C)Ph | tBu | H | CF₃ | N |
| **E-120** | 4-F-Ph | tBu | H | F | N |
| **E-121** | 4-NC-Ph | tBu | H | CN | N |
| **E-122** | Ph | Ph | H | H | N |
| **E-123** | 3-tBu-Ph | Ph | tBu | H | N |
| **E-124** | 3-(Me₃Si)Ph | Ph | SiMe₃ | H | N |
| **E-125** | 3-(F₃C)Ph | Ph | CF₃ | H | N |
| **E-126** | 3-F-Ph | Ph | F | H | N |
| **E-127** | 4-tBu-Ph | Ph | H | tBu | N |
| **E-128** | 4-(Me₃Si)Ph | Ph | H | SiMe₃ | N |
| **E-129** | 4-(F₃C)Ph | Ph | H | CF₃ | N |
| **E-130** | 4-F-Ph | Ph | H | F | N |
| **E-131** | 4-NC-Ph | Ph | H | CN | N |
| **E-132** | Ph | DIPP | H | H | N |
| **E-133** | 3-tBu-Ph | DIPP | tBu | H | N |
| **E-134** | 3-(Me₃Si)Ph | DIPP | SiMe₃ | H | N |
| **E-135** | 3-(F₃C)Ph | DIPP | CF₃ | H | N |
| **E-136** | 3-F-Ph | DIPP | F | H | N |
| **E-137** | 4-tBu-Ph | DIPP | H | tBu | N |
| **E-138** | 4-(Me₃Si)Ph | DIPP | H | SiMe₃ | N |
| **E-139** | 4-(F₃C)Ph | DIPP | H | CF₃ | N |
| **E-140** | 4-F-Ph | DIPP | H | F | N |
| **E-141** | 4-NC-Ph | DIPP | H | CN | N |
| **E-142** | Ph | TMP | H | H | N |
| **E-143** | 3-tBu-Ph | TMP | tBu | H | N |
| **E-144** | 3-(Me₃Si)Ph | TMP | SiMe₃ | H | N |
| **E-145** | 3-(F₃C)Ph | TMP | CF₃ | H | N |
| **E-146** | 3-F-Ph | TMP | F | H | N |
| **E-147** | 4-tBu-Ph | TMP | H | tBu | N |
| **E-148** | 4-(Me₃Si)Ph | TMP | H | SiMe₃ | N |
| **E-149** | 4-(F₃C)Ph | TMP | H | CF₃ | N |
| **E-150** | 4-F-Ph | TMP | H | F | N |
| **E-151** | 4-NC-Ph | TMP | H | CN | N |
| **E-152** | TMP | Me | H | H | N |
| **E-153** | TMP | Me | tBu | H | N |
| **E-154** | TMP | Me | SiMe₃ | H | N |
| **E-155** | TMP | Me | CF₃ | H | N |
| **E-156** | TMP | Me | F | H | N |
| **E-157** | TMP | Me | H | tBu | N |
| **E-158** | TMP | Me | H | SiMe₃ | N |
| **E-159** | TMP | Me | H | CF₃ | N |
| **E-160** | TMP | Me | H | F | N |
| **E-161** | TMP | Me | H | CN | N |
| **E-162** | TMP | tBu | H | H | N |
| **E-163** | TMP | tBu | tBu | H | N |
| **E-164** | TMP | tBu | SiMe₃ | H | N |
| **E-165** | TMP | tBu | CF₃ | H | N |
| **E-166** | TMP | tBu | F | H | N |
| **E-167** | TMP | tBu | H | tBu | N |
| **E-168** | TMP | tBu | H | SiMe₃ | N |
| **E-169** | TMP | tBu | H | CF₃ | N |
| **E-170** | TMP | tBu | H | F | N |
| **E-171** | TMP | tBu | H | CN | N |
| **E-172** | TMP | Ph | H | H | N |
| **E-173** | TMP | Ph | tBu | H | N |
| **E-174** | TMP | Ph | SiMe₃ | H | N |
| **E-175** | TMP | Ph | CF₃ | H | N |
| **E-176** | TMP | Ph | F | H | N |
| **E-177** | TMP | Ph | H | tBu | N |
| **E-178** | TMP | Ph | H | SiMe₃ | N |
| **E-179** | TMP | Ph | H | CF₃ | N |
| **E-180** | TMP | Ph | H | F | N |
| **E-181** | TMP | Ph | H | CN | N |
| **E-182** | TMP | DIPP | H | H | N |
| **E-183** | TMP | DIPP | tBu | H | N |
| **E-184** | TMP | DIPP | SiMe₃ | H | N |
| **E-185** | TMP | DIPP | CF₃ | H | N |
| **E-186** | TMP | DIPP | F | H | N |
| **E-187** | TMP | DIPP | H | tBu | N |
| **E-188** | TMP | DIPP | H | SiMe₃ | N |
| **E-189** | TMP | DIPP | H | CF₃ | N |
| **E-190** | TMP | DIPP | H | F | N |
| **E-191** | TMP | DIPP | H | CN | N |
| **E-192** | TMP | TMP | H | H | N |
| **E-193** | TMP | TMP | tBu | H | N |
| **E-194** | TMP | TMP | SiMe₃ | H | N |
| **E-195** | TMP | TMP | CF₃ | H | N |
| **E-196** | TMP | TMP | F | H | N |
| **E-197** | TMP | TMP | H | tBu | N |
| **E-198** | TMP | TMP | H | SiMe₃ | N |
| **E-199** | TMP | TMP | H | CF₃ | N |
| **E-200** | TMP | TMP | H | F | N |
| **E-201** | TMP | TMP | H | CN | N |
| **E-202** | DMP | Me | H | H | N |
| **E-203** | DMP | Me | tBu | H | N |
| **E-204** | DMP | Me | SiMe₃ | H | N |
| **E-205** | DMP | Me | CF₃ | H | N |
| **E-206** | DMP | Me | F | H | N |
| **E-207** | DMP | Me | H | tBu | N |
| **E-208** | DMP | Me | H | SiMe₃ | N |
| **E-209** | DMP | Me | H | CF₃ | N |
| **E-210** | DMP | Me | H | F | N |
| **E-211** | DMP | Me | H | CN | N |
| **E-212** | DMP | tBu | H | H | N |
| **E-213** | DMP | tBu | tBu | H | N |
| **E-214** | DMP | tBu | SiMe₃ | H | N |
| **E-215** | DMP | tBu | CF₃ | H | N |
| **E-216** | DMP | tBu | F | H | N |
| **E-217** | DMP | tBu | H | tBu | N |
| **E-218** | DMP | tBu | H | SiMe₃ | N |
| **E-219** | DMP | tBu | H | CF₃ | N |
| **E-220** | DMP | tBu | H | F | N |
| **E-221** | DMP | tBu | H | CN | N |
| **E-222** | DMP | Ph | H | H | N |
| **E-223** | DMP | Ph | tBu | H | N |
| **E-224** | DMP | Ph | SiMe₃ | H | N |
| **E-225** | DMP | Ph | CF₃ | H | N |
| **E-226** | DMP | Ph | F | H | N |
| **E-227** | DMP | Ph | H | tBu | N |
| **E-228** | DMP | Ph | H | SiMe₃ | N |
| **E-229** | DMP | Ph | H | CF₃ | N |
| **E-230** | DMP | Ph | H | F | N |
| **E-231** | DMP | Ph | H | CN | N |
| **E-232** | DMP | DIPP | H | H | N |
| **E-233** | DMP | DIPP | tBu | H | N |
| **E-234** | DMP | DIPP | SiMe₃ | H | N |
| **E-235** | DMP | DIPP | CF₃ | H | N |
| **E-236** | DMP | DIPP | F | H | N |
| **E-237** | DMP | DIPP | H | tBu | N |
| **E-238** | DMP | DIPP | H | SiMe₃ | N |
| **E-239** | DMP | DIPP | H | CF₃ | N |
| **E-240** | DMP | DIPP | H | F | N |
| **E-241** | DMP | DIPP | H | CN | N |
| **E-242** | DMP | TMP | H | H | N |
| **E-243** | DMP | TMP | tBu | H | N |
| **E-244** | DMP | TMP | SiMe₃ | H | N |
| **E-245** | DMP | TMP | CF₃ | H | N |
| **E-246** | DMP | TMP | F | H | N |
| **E-247** | DMP | TMP | H | tBu | N |
| **E-248** | DMP | TMP | H | SiMe₃ | N |
| **E-249** | DMP | TMP | H | CF₃ | N |
| **E-250** | DMP | TMP | H | F | N |
| **E-251** | DMP | TMP | H | CN | N |
| **E-252** | DIPP | Me | H | H | N |
| **E-253** | DIPP | Me | tBu | H | N |
| **E-254** | DIPP | Me | SiMe₃ | H | N |
| **E-255** | DIPP | Me | CF₃ | H | N |
| **E-256** | DIPP | Me | F | H | N |
| **E-257** | DIPP | Me | H | tBu | N |
| **E-258** | DIPP | Me | H | SiMe₃ | N |
| **E-259** | DIPP | Me | H | CF₃ | N |
| **E-260** | DIPP | Me | H | F | N |
| **E-261** | DIPP | Me | H | CN | N |
| **E-262** | DIPP | tBu | H | H | N |
| **E-263** | DIPP | tBu | tBu | H | N |
| **E-264** | DIPP | tBu | SiMe₃ | H | N |
| **E-265** | DIPP | tBu | CF₃ | H | N |
| **E-266** | DIPP | tBu | F | H | N |
| **E-267** | DIPP | tBu | H | tBu | N |
| **E-268** | DIPP | tBu | H | SiMe₃ | N |
| **E-269** | DIPP | tBu | H | CF₃ | N |
| **E-270** | DIPP | tBu | H | F | N |
| **E-271** | DIPP | tBu | H | CN | N |
| **E-272** | DIPP | Ph | H | H | N |
| **E-273** | DIPP | Ph | tBu | H | N |
| **E-274** | DIPP | Ph | SiMe₃ | H | N |
| **E-275** | DIPP | Ph | CF₃ | H | N |
| **E-276** | DIPP | Ph | F | H | N |
| **E-277** | DIPP | Ph | H | tBu | N |
| **E-278** | DIPP | Ph | H | SiMe₃ | N |
| **E-279** | DIPP | Ph | H | CF₃ | N |
| **E-280** | DIPP | Ph | H | F | N |
| **E-281** | DIPP | Ph | H | CN | N |
| **E-282** | DIPP | DIPP | H | H | N |
| **E-283** | DIPP | DIPP | tBu | H | N |
| **E-284** | DIPP | DIPP | SiMe₃ | H | N |
| **E-285** | DIPP | DIPP | CF₃ | H | N |
| **E-286** | DIPP | DIPP | F | H | N |
| **E-287** | DIPP | DIPP | H | tBu | N |
| **E-288** | DIPP | DIPP | H | SiMe₃ | N |
| **E-289** | DIPP | DIPP | H | CF₃ | N |
| **E-290** | DIPP | DIPP | H | F | N |
| **E-291** | DIPP | DIPP | H | CN | N |
| **E-292** | DIPP | TMP | H | H | N |
| **E-293** | DIPP | TMP | tBu | H | N |
| **E-294** | DIPP | TMP | SiMe₃ | H | N |
| **E-295** | DIPP | TMP | CF₃ | H | N |
| **E-296** | DIPP | TMP | F | H | N |
| **E-297** | DIPP | TMP | H | tBu | N |
| **E-298** | DIPP | TMP | H | SiMe₃ | N |
| **E-299** | DIPP | TMP | H | CF₃ | N |
| **E-300** | DIPP | TMP | H | F | N |
| **E-301** | DIPP | TMP | H | CN | N |

| | | | | | |
|---|---|---|---|---|---|
| DIPP = 2,6-Diisopropylphenyl, TIPP = 2,4,6-Triisopropylphenyl, TMP = 2,4,6-Trimethylphenyl, DMP = 3,5-Dimethylphenyl. | | | | | |

In a particularly preferred embodiment the present invention is directed to compounds of formula 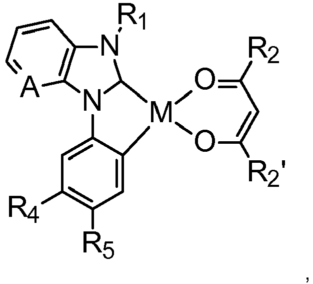 wherein
A is CH, or N; preferably CH;
R₁ is phenyl, 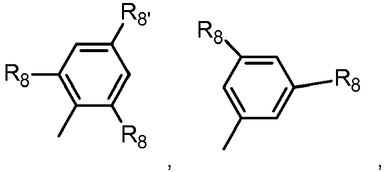 wherein R₈ is C₁-C₄alkyl and R_{8'} is H, or C₁-C₄alkyl; 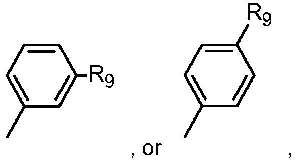 wherein R₉ is CF₃, C₁-C₄alkyl, F, or Si(CH₃)₃;
R₂ and R_{2'} are C₁-C₆alkyl, especially methyl, or tert-butyl; phenyl, or a group of formula 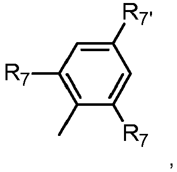 wherein R₇ is C₁-C₄alkyl and R_{7'} is H, or C₁-C₄alkyl;
R₄ is H, CF₃, or C₁-C₄alkyl, especially tert-butyl; and
R₅ is H, CF₃, or C₁-C₄alkyl, especially tert-butyl.

A process for preparing the metal-carbene complexes according to the present invention comprises by contacting suitable compounds comprising M with compounds of the general formula 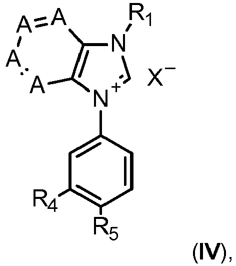 wherein
R₁, R₄ R₅ and A are each as defined above and
X is F, Cl, Br, I, PF₆, or BF₄.

Customary processes involve, for example, the deprotonation of the imidazole ligand precursors of formula (**IV**) and subsequent reaction, generally in situ, with suitable Pt/Pd-comprising metal compounds and optionally precursors of ligand L.

The process for preparing the inventive metal-carbene complexes is illustrated below in more detail on basis of inventive platinum-carbene complexes of formula **I**, wherein L is a ligand of formula 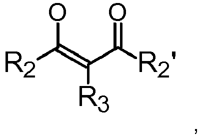 but is not limited thereto.

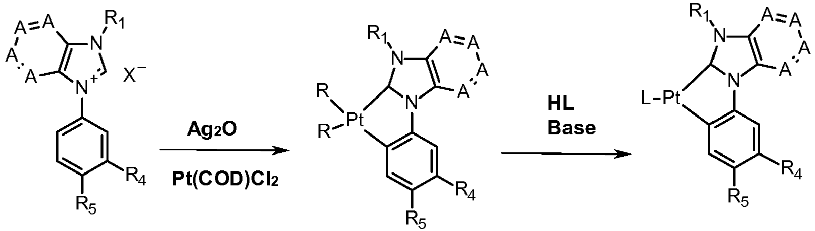

The process comprises the following steps:
(i) the deprotonation of the imidazole ligand precursors of formula (**IV**);
(ii) subsequent reaction with suitable Pt-comprising metal compounds; and
(iii) reaction of the intermediate obtained in step ii) with HL in the presence of a base.

Deprotonation in step i) can be accomplished by basic compounds known to those skilled in the art, for example basic metallates, basic metal acetates, acetylacetonates or alkoxylates, or bases such as KO^{t}Bu, NaO^{t}Bu, LiO^{t}Bu, NaH, silylamides and phosphazene bases. Preference is given to deprotonating with Ag₂O.

The deprotonation is preferably effected in a solvent. Suitable solvents are known per se to those skilled in the art and are preferably selected from the group consisting of aromatic and aliphatic solvents, ethers, alcohols, esters, amides, ketones, nitriles, halogenated compounds and mixtures thereof. A particularly preferred solvent is dioxane.

The reaction is effected generally at a temperature of 0 to 50°C. The reaction time depends on the desired Pt-carbene complex and is generally 1 to 80 hours, preferably 2 to 70 hours, more preferably 10 to 60 hours.

Then the deprotonated imidazole ligand precursors of formula (**IV**) are reacted with suitable Pt-comprising metal compounds.

In general, suitable Pt salts are all of those which are known to those skilled in the art and exhibit a sufficiently high reactivity under the inventive reaction conditions. Preference is given to corresponding Pt salts or complexes selected from the group consisting of Pt(COD)Cl₂ (COD = cyclooctadiene), Pt(PPh₃)₂Cl₂, Pt(pyridine)₂Cl₂, [PtMe₂(SMe₂)]₂, Pt(SMe₂)₂Cl₂, Pt(SEt₂)₂Cl₂, Pt(phenanthroline)Cl₂, Pt(NH₃)₂Cl₂, PtCl₂, K₂PtCl₄ and mixtures thereof, particular preference being given to using Pt(COD)Cl₂.

The reaction is preferably effected in a solvent. Suitable solvents are known per se to those skilled in the art and are preferably selected from the group consisting of aromatic and aliphatic solvents, ethers, alcohols, esters, amides, ketones, nitriles, halogenated compounds and mixtures thereof. A particularly preferred solvent is a mixture of dioxane and 2-butanone.

The reaction is effected generally at a temperature of 0 to 150°C. The reaction time depends on the desired Pt-carbene complex and is generally 1 to 80 hours, preferably 2 to 70 hours, more preferably 10 to 60 hours.

Afterwards all volatiles are removed and the intermediate obtained in step ii) is reacted with HL in the presence of a base, such as, for example, potassium tert-butanolate. The reaction is preferably effected in a solvent, such as, for example, dimethyl formamide.

The reaction is effected generally at a temperature of 0 to 150°C. The reaction time depends on the desired Pt-carbene complex and is generally 1 to 80 hours.

The resulting inventive metal-carbene complex is worked up by methods known to those skilled in the art. For example, the product which precipitates out during the reaction is filtered, washed and then dried. Flash chromatography and/or recrystallization affords high-purity inventive metal-carbene complexes.

In the context of the present invention, the terms aryl radical, unit or group, heteroaryl radical, unit or group, alkyl radical, unit or group, cycloalkyl radical, unit or group, and groups with donor or acceptor action are each defined as follows - unless stated otherwise:
Aryl radicals or substituted or unsubstituted aryl radicals having 6 to 30 carbon atoms (C₆-C₃₀-aryl radicals) refer in the present invention to radicals which are derived from monocyclic, bicyclic or tricyclic aromatics which do not comprise any ring heteroatoms. When the systems are not monocyclic systems, the term "aryl" for the second ring also includes the saturated form (perhydro form) or the partly unsaturated form (for example the dihydro form or tetrahydro form), provided that the particular forms are known and stable. This means that the term "aryl" in the present invention encompasses, for example, also bicyclic or tricyclic radicals in which either both or all three radicals are aromatic, and bicyclic or tricyclic radicals in which only one ring is aromatic, and also tricyclic radicals in which two rings are aromatic. Examples of aryl are: phenyl, naphthyl, indanyl, 1,2-dihydronaphthenyl, 1,4-dihydronaphthenyl, indenyl, anthracenyl, phenanthrenyl or 1,2,3,4-tetrahydronaphthyl. Particular preference is given to C₆-C₁₀-aryl radicals, for example phenyl or naphthyl, very particular preference to C₆-aryl radicals, for example phenyl.

The aryl radicals or C₆-C₃₀-aryl radicals may be unsubstituted or substituted by one or more further radicals. Suitable further radicals are selected from the group consisting of C₁-C₂₀-alkyl, C₆-C₃₀-aryl and substituents with donor or acceptor action, suitable substituents with donor or acceptor action are specified below. The C₆-C₃₀-aryl radicals are preferably unsubstituted or substituted by one or more C₁-C₂₀-alkyl groups, C₁-C₂₀-alkoxy groups, CN, CF₃, F or amino groups (NR⁶²R⁶³ where suitable R⁶² and R⁶³ radicals are specified below).

Heteroaryl radicals or substituted or unsubstituted heteroaryl radicals having a total of 5 to 18 carbon atoms and/or heteroatoms are understood to mean monocyclic, bicyclic or tricyclic heteroaromatics, some of which can be derived from the aforementioned aryl, in which at least one carbon atom in the aryl base structure has been replaced by a heteroatom. Preferred heteroatoms are N, O and S. The heteroaryl radicals more preferably have 5 to 13 ring atoms. The base structure of the heteroaryl radicals is especially preferably selected from systems such as pyridine and five-membered heteroaromatics such as thiophene, pyrrole, imidazole, thiazole, oxazole or furan. These base structures may optionally be fused to one or two six-membered aromatic radicals. Suitable fused heteroaromatics are carbazolyl, benzimidazolyl, benzofuryl, benzothiazolyl, benzoxazolyl, dibenzofuryl or dibenzothiophenyl.

The base structure may be substituted at one, more than one or all substitutable positions, suitable substituents being the same as those already specified under the definition of C₆-C₃₀-aryl. However, the heteroaryl radicals are preferably unsubstituted. Suitable heteroaryl radicals are, for example, pyridin-2-yl, pyridin-3-yl, pyridin-4-yl, thiophen-2-yl, thiophen-3-yl, pyrrol-2-yl, pyrrol-3-yl, furan-2-yl, furan-3-yl, thiazol-2-yl, oxazol-2-yl and imidazol-2-yl, and the corresponding benzofused radicals, especially carbazolyl, benzimidazolyl, benzofuryl, benzothiazolyl, benzoxazolyl, dibenzofuryl or dibenzothiophenyl.

An alkyl radical in the context of the present application is a linear or branched alkyl radical optionally bearing at least one functional group, optionally interrupted by at least one heteroatom and having 1 to 20 carbon atoms. Preference is given to C₁- to C₁₀-alkyl radicals, particular preference to C₁- to C₆-alkyl radicals. In addition, the alkyl radicals may be substituted by one or more functional groups, preferably selected from the group consisting of C₁-C₂₀-alkyl, C₁-C₂₀-alkoxy, halogen, preferably F, C₁-C₂₀-haloalkyl, e.g. CF₃, and C₆-C₃₀-aryl which may in turn be substituted or unsubstituted. Suitable aryl substituents and suitable alkoxy and halogen substituents are specified below. Examples of suitable alkyl groups are methyl, ethyl, propyl, butyl, pentyl, hexyl, heptyl and octyl, and also C₁-C₂₀-alkyl-, C₁-C₂₀-haloalkyl-, C₆-C₃₀-aryl-, C₁-C₂₀-alkoxy- and/or halogen-substituted, especially F-substituted, derivatives of the alkyl groups mentioned, for example CF₃. This comprises both the n-isomers of the radicals mentioned and branched isomers such as isopropyl, isobutyl, isopentyl, sec-butyl, tert-butyl, neopentyl, 3,3-dimethylbutyl, 3-ethylhexyl, etc. Preferred alkyl groups are methyl, ethyl, isopropyl, tert-butyl and CF₃.

A cycloalkyl radical or a substituted or unsubstituted cycloalkyl radical having 3 to 20 carbon atoms is understood in the context of the present application to mean a substituted or unsubstituted C₃-C₂₀-cycloalkyl radical. Preferred are cycloalkyl radicals having 5 to 20, more preferably 5 to 10 and most preferably 5 to 8 carbon atoms in the base structure (ring) to understand. Suitable substituents are the substituents mentioned for the alkyl groups. Examples of suitable cycloalkyl groups, which may be unsubstituted or substituted by the radicals mentioned above for the alkyl groups, are cyclopentyl, cyclohexyl, cycloheptyl, cyclooctyl, cyclononyl and cyclodecyl. They may also be polycyclic ring systems such as decalinyl, norbornyl, bornanyl or adamantyl.

Suitable alkoxy radicals derive correspondingly from the aforementioned alkyl radicals. Examples here include OCH₃, OC₂H₅, OC₃H₇, OC₄H₉ and OC₈H₁₇, and also SCH₃, SC₂H₅, SC₃H₇, SC₄H₉ and SC₈H₁₇. In this context, C₃H₇, C₄H₉ and C₈H₁₇ comprise both the n-isomers and branched isomers such as isopropyl, isobutyl, sec-butyl, tert-butyl and 2-ethylhexyl. Particularly preferred alkoxy or alkylthio groups are methoxy, ethoxy, n-octyloxy, 2-ethylhexyloxy and SCH₃.

Suitable halogen radicals or halogen substituents in the context of the present application are fluorine, chlorine, bromine and iodine, preferably fluorine, chlorine and bromine, more preferably fluorine and chlorine, most preferably fluorine.

In the context of the present application, groups with donor or acceptor action are understood to mean the following groups:
C₁-C₂₀-alkoxy, C₆-C₃₀-aryloxy, C₁-C₂₀-alkylthio, C₆-C₃₀-arylthio, SiR⁶⁴R⁶⁵R⁶⁶, halogen radicals, halogenated C₁-C₂₀-alkyl radicals, carbonyl (-CO(R⁶⁴)), carbonylthio (- C = O (SR⁶⁴)), carbonyloxy (- C = O(OR⁶⁴)), oxycarbonyl (- OC = O(R⁶⁴)), thiocarbonyl (- SC = O(R⁶⁴)), amino (-NR⁶⁴R⁶⁵), OH, pseudohalogen radicals, amido (- C = O (NR⁶⁴R⁶⁵)), - NR⁶⁴C = O (R⁶⁵), phosphonate (- P(O) (OR⁶⁴)₂, phosphate (-OP(O) (OR⁶⁴)₂), phosphine (-PR⁶⁴R⁶⁵), phosphine oxide (-P(O)R⁶⁴₂), sulfate (-OS(O)₂OR⁶⁴), sulfoxide (-S(O)R⁶⁴), sulfonate (-S(O)₂OR⁶⁴), sulfonyl (-S(O)₂R⁶⁴), sulfonamide (-S(O)₂NR⁶⁴R⁶⁵), NO₂, boronic esters (-OB(OR⁶⁴)₂), imino (-C = NR⁶⁴R⁶⁵)), borane radicals, stannate radicals, hydrazine radicals, hydrazone radicals, oxime radicals, nitroso groups, diazo groups, vinyl groups, sulfoximines, alanes, germanes, boroxines and borazines.

Preferred substituents with donor or acceptor action are selected from the group consisting of: C₁- to C₂₀-alkoxy, preferably C₁-C₆-alkoxy, more preferably ethoxy or methoxy; C₆-C₃₀-aryloxy, preferably C₆-C₁₀-aryloxy, more preferably phenyloxy; SiR⁶⁴R⁶⁵R⁶⁶, where R⁶⁴, R⁶⁵ and R⁶⁶ are preferably each independently substituted or unsubstituted alkyl or substituted or unsubstituted phenyl, suitable substituents having been specified above; halogen radicals, preferably F, Cl, Br, more preferably F or Cl, most preferably F, halogenated C₁-C₂₀-alkyl radicals, preferably halogenated C₁-C₆-alkyl radicals, most preferably fluorinated C₁-C₆-alkyl radicals, e.g. CF₃, CH₂F, CHF₂ or C₂F₅; amino, preferably dimethylamino, diethylamino or diphenylamino; OH, pseudohalogen radicals, preferably CN, SCN or OCN, more preferably CN, -C(O)OC₁-C₄-alkyl, preferably -C(O)OMe, P(O)R₂, preferably P(O)Ph₂, and SO₂R₂, preferably SO₂Ph.

Very particularly preferred substituents with donor or acceptor action are selected from the group consisting of methoxy, phenyloxy, halogenated C₁-C₄-alkyl, preferably CF₃, CH₂F, CHF₂, C₂F₅, halogen, preferably F, CN, SiR⁶⁴R⁶⁵R⁶⁶, where suitable R⁶⁴, R⁶⁵ and R⁶⁶ radicals have been specified above, diphenylamino, -C(O)OC₁-C₄-alkyl, preferably - C(O)OMe, P(O)Ph₂ and SO₂Ph.

The aforementioned groups with donor or acceptor action are not intended to rule out the possibility that further radicals and groups among those specified above may also have donor or acceptor action. For example, the aforementioned heteroaryl radicals are likewise groups with donor or acceptor action, and the C₁-C₂₀-alkyl radicals are groups with donor action.

The inventive metal-carbene complexes can be used in electronic components, for example organic electronic components selected from switching elements such as organic light-emitting diodes (OLEDs), organic photovoltaic cells (OPVs), organic field-effect transistors (OFETs) and light-emitting electrochemical cells (LEECs), preference being given to using the metal-carbene complexes of the formula (I) in OLEDs.

In a preferred embodiment, the organic electronic component is an OLED comprising a light-emitting layer comprising at least one inventive metal-carbene complexe.

The aforementioned inventive metal-carbene complexes and mixtures thereof are outstandingly suitable as emitter molecules in organic light-emitting diodes (OLEDs). Variations in the ligands make it possible to provide corresponding complexes which exhibit electroluminescence in a wide range of the electromagnetic spectrum. The inventive metal-carbene complexes are therefore outstandingly suitable as emitter substances and it is thus possible, with the aid of the inventive complexes as emitter substances, to provide industrially usable OLEDs.

In addition, the inventive metal-carbene complexes can be used as matrix material, charge transport material, especially hole transport material, and/or charge blocker.

The inventive metal-carbene complexes are preferably used as an emitter and/or charge transport material and/or matrix material, more preferably as an emitter.

Particular properties of the inventive metal-carbene complexes are particularly good efficiencies, good CIE color loci and long lifetimes when used in OLEDs.

The present application therefore further provides an OLED comprising at least one inventive metal-carbene complex. The inventive metal-carbene complex is used in the OLED preferably as an emitter, matrix material, charge transport material, especially hole transport material, and/or charge blocker, more preferably as an emitter and/or hole transport material, most preferably as an emitter.

The present application also provides for the use of the inventive metal-carbene complexes in OLEDs, preferably as an emitter, matrix material, charge transport material, especially hole transport material, and/or charge blocker, more preferably as an emitter and/or hole transport material, most preferably as an emitter.

Organic light-emitting diodes are in principle formed from a plurality of layers, e.g.:
- anode (1)
- hole-transporting layer (2)
- light-emitting layer (3)
- electron-transporting layer (4)
- cathode (5)

It is, however, also possible that the OLED does not have all of the layers mentioned; for example, an OLED comprising layers (1) (anode), (3) (light-emitting layer) and (5) (cathode) is likewise suitable, in which case the functions of layers (2) (hole-transporting layer) and (4) (electron-transporting layer) are assumed by the adjoining layers. OLEDs having layers (1), (2), (3) and (5) or layers (1), (3), (4) and (5) are likewise suitable.

The inventive metal-carbene complexes are preferably used as emitter molecules and/or matrix materials in the light-emitting layer (3). The inventive metal-carbene complexes may - in addition to use as emitter molecules and/or matrix materials in the light-emitting layer (3) or instead of use in the light-emitting layer - also be used as a charge transport material in the hole-transporting layer (2) or in the electron-transporting layer (4) and/or as a charge blocker, preference being given to use as a charge transport material in the hole-transporting layer (2) (hole transport material).

The present application therefore further provides a light-emitting layer comprising at least one of the inventive metal-carbene complexes, preferably as emitter material and/or matrix material, more preferably as emitter material. Preferred inventive metal-carbene complexes have already been specified above.

In a further embodiment, the present invention relates to a light-emitting layer consisting of at least one inventive metal-carbene complex.

The inventive metal-carbene complexes used in accordance with the invention may be present in the light-emitting layer in substance, i.e. without further additions. However, it is also possible that, in addition to the dinuclear metal-carbene complexes used in accordance with the invention, further compounds are present in the light-emitting layer. In addition, a diluent material (matrix material) may be used. This diluent material may be a polymer, for example poly(N-vinylcarbazole) or polysilane. The diluent material may, however, likewise be a small molecule, for example 4,4'-N,N'-dicarbazolebiphenyl (CDP) or tertiary aromatic amines. When a diluent material is used, the proportion of the inventive metal-carbene complexes in the light-emitting layer is generally less than 40% by weight, preferably 3 to 30% by weight. The inventive metal-carbene complexes are preferably used in a matrix. The light-emitting layer thus preferably comprises at least one inventive metal-carbene complex and at least one matrix material.

Suitable matrix materials are - in addition to the aforementioned dilution materials - in principle the materials specified hereinafter as hole and electron transport materials, and also carben complexes, for example, the inventive metal-carbene complexes, or the carbene complexes mentioned in WO 2005/019373. Particularly suitable are carbazole derivatives, for example 4,4'-bis(carbazol-9-yl)-2,2'-dimethylbiphenyl (CDBP), 4,4'-bis(carbazol-9-yl)biphenyl (CBP), 1,3-bis(N-carbazolyl)benzene (mCP), and the matrix materials specified in the following applications: WO2008/034758, WO2009/003919.

Further suitable matrix materials, which may be small molecules or (co)polymers of the small molecules mentioned, are specified in the following publications: WO2007108459 (H-1 to H-37), preferably H-20 to H-22 and H-32 to H-37, most preferably H-20, H-32, H-36, H-37, WO2008035571 A1 (Host 1 to Host 6), JP2010135467 (compounds 1 to 46 and Host-1 to Host-39 and Host-43), WO2009008100 compounds No.1 to No.67, preferably No.3, No.4, No.7 to No. 12, No.55, No.59, No. 63 to No.67, more preferably No. 4, No. 8 to No. 12, No. 55, No. 59, No.64, No.65, and No. 67, WO2009008099 compounds No. 1 to No. 110, WO2008140114 compounds 1-1 to 1-50, WO2008090912 compounds OC-7 to OC-36 and the polymers of Mo-42 to Mo-51, JP2008084913 H-1 to H-70, WO2007077810 compounds 1 to 44, preferably 1, 2, 4-6, 8, 19-22, 26, 28-30, 32, 36, 39-44, WO201001830 the polymers of monomers 1-1 to 1-9, preferably of 1-3, 1-7, and 1-9, WO2008029729 the (polymers of) compounds 1-1 to 1-36, WO20100443342 HS-1 to HS-101 and BH-1 to BH-17, preferably BH-1 to BH-17, JP2009182298 the (co)polymers based on the monomers 1 to 75, JP2009170764, JP2009135183 the (co)polymers based on the monomers 1-14, WO2009063757 preferably the (co)polymers based on the monomers 1-1 to 1-26, WO2008146838 the compounds a-1 to a-43 and 1-1 to 1-46, JP2008207520 the (co)polymers based on the monomers 1-1 to 1-26, JP2008066569 the (co)polymers based on the monomers 1-1 to 1-16, WO2008029652 the (co)polymers based on the monomers 1-1 to 1-52, WO2007114244 the (co)polymers based on the monomers 1-1 to 1-18, JP2010040830 the compounds HA-1 to HA-20, HB-1 to HB-16, HC-1 to HC-23 and the (co)polymers based on the monomers HD-1 to HD-12, JP2009021336, WO2010090077 the compounds 1 to 55, WO2010079678 the compounds H1 to H42, WO2010067746, WO2010044342 the compounds HS-1 to HS-101 and Poly-1 to Poly-4, JP2010114180 the compounds PH-1 to PH-36, US2009284138 the compounds 1 to 111 and H1 to H71, WO2008072596 the compounds 1 to 45, JP2010021336 the compounds H-1 to H-38, preferably H-1, WO2010004877 the compounds H-1 to H-60, JP2009267255 the compounds 1-1 to 1-105, WO2009104488 the compounds 1-1 to 1-38, WO2009086028, US2009153034, US2009134784, WO2009084413 the compounds 2-1 to 2-56, JP2009114369 the compounds 2-1 to 2-40, JP2009114370 the compounds 1 to 67, WO2009060742 the compounds 2-1 to 2-56, WO2009060757 the compounds 1-1 to 1-76, WO2009060780 the compounds 1-1 to 1-70, WO2009060779 the compounds 1-1 to 1-42, WO2008156105 the compounds 1 to 54, JP2009059767 the compounds 1 to 20, JP2008074939 the compounds 1 to 256, JP2008021687 the compounds 1 to 50, WO2007119816 the compounds 1 to 37, WO2010087222 the compounds H-1 to H-31, WO2010095564 the compounds HOST-1 to HOST-61, WO2007108362, WO2009003898, WO2009003919, WO2010040777, US2007224446, WO06128800 and PCT/EP2012/055064.

In a particularly preferred embodiment, one or more compounds of the general formula (X) specified hereinafter are used as matrix material. Preferred embodiments of the compounds of the general formula (X) are likewise specified hereinafter.

The individual layers among the aforementioned layers of the OLED may in turn be formed from two or more layers. For example, the hole-transporting layer may be formed from one layer, into which holes are injected from the electrode, and a layer which transports the holes away from the hole-injecting layer into the light-emitting layer. The electron-transporting layer may likewise consist of a plurality of layers, for example of a layer in which electrons are injected through the electrode and a layer which receives electrons from the electron-injecting layer and transports them into the light-emitting layer. These layers mentioned are each selected according to factors such as energy level, thermal resistance and charge carrier mobility, and also energy difference of the layers mentioned with the organic layers or the metal electrodes. The person skilled in the art is capable of selecting the construction of the OLEDs such that it is matched optimally to the inventive metal-carbene complexes used as emitter substances in accordance with the invention.

In order to obtain particularly efficient OLEDs, the HOMO (highest occupied molecular orbital) of the hole-transporting layer should be aligned to the work function of the anode, and the LUMO (lowest unoccupied molecular orbital) of the electron-transporting layer should be aligned to the work function of the cathode.

The present application further provides an OLED comprising at least one inventive light-emitting layer. The further layers in the OLED may be formed from any material which is typically used in such layers and is known to those skilled in the art.

Suitable materials for the aforementioned layers (anode, cathode, hole and electron injection materials, hole and electron transport materials and hole and electron blocker materials, matrix materials, fluorescence and phosphorescence emitters) are known to those skilled in the art and are specified, for example, in H. Meng, N. Herron, Organic Small Molecule Materials for Organic Light-Emitting Devices in Organic Light-Emitting Materials and Devices, eds: Z. Li, H. Meng, Taylor & Francis, 2007, Chapter 3, pages 295 to 411.

The anode is an electrode which provides positive charge carriers. It may be composed, for example, of materials which comprise a metal, a mixture of different metals, a metal alloy, a metal oxide or a mixture of different metal oxides. Alternatively, the anode may be a conductive polymer. Suitable metals comprise the metals of groups 11, 4, 5 and 6 of the Periodic Table of the Elements, and also the transition metals of groups 8 to 10. When the anode is to be transparent, mixed metal oxides of groups 12, 13 and 14 of the Periodic Table of the Elements are generally used, for example indium tin oxide (ITO). It is likewise possible that the anode (1) comprises an organic material, for example polyaniline, as described, for example, in Nature, Vol. 357, pages 477 to 479 (June 11, 1992). At least either the anode or the cathode should be at least partly transparent in order to be able to emit the light formed.

Suitable hole transport materials for layer (2) of the inventive OLED are disclosed, for example, in Kirk-Othmer Encyclopedia of Chemical Technology, 4th Edition, Vol. 18, pages 837 to 860, 1996. Either hole-transporting molecules or polymers may be used as the hole transport material. Customarily used hole-transporting molecules are selected from the group consisting of 4,4'-bis[N-(1-naphthyl)-N-phenylamino]biphenyl (a-NPD), N,N'-diphenyl-N,N'-bis(3-methylphenyl)-[1,1'-biphenyl]-4,4'-diamine (TPD), 1,1-bis[(di-4-tolylamino)phenyl]cyclohexane (TAPC), N,N'-bis(4-methylphenyl)N,N'-bis(4-ethylphenyl)-[1,1'-(3,3'-dimethyl)biphenyl]-4,4'-diamine (ETPD), tetrakis(3-methylphenyl)-N,N,N',N'-2,5-phenylenediamine (PDA), α-phenyl-4-N,N-diphenylaminostyrene (TPS), p-(diethylamino)benzaldehyde diphenylhydrazone (DEH), triphenylamine (TPA), bis[4-(N,N-diethylamino)2-methylphenyl](4-methylphenyl)methane (MPMP), 1-phenyl-3-[p-(diethylamino)styryl]5-[p-(diethylamino)phenyl]pyrazoline (PPR or DEASP), 1,2-trans-bis(9H-carbazol9-yl)-cyclobutane (DCZB), N,N,N',N'-tetrakis(4-methylphenyl)-(1,1'-biphenyl)4,4'-diamine (TTB), fluorine compounds such as 2,2',7,7'-tetra(N,N-di-tolyl)amino-9,9-spirobifluorene (spiro-TTB), N,N'-bis(naphthalen-1-yl)-N,N'-bis(phenyl)9,9-spirobifluorene (spiro-NPB) and 9,9-bis(4-(N,N-bis-biphenyl-4-yl-amino)phenyl-9Hfluorene, benzidine compounds such as N,N'-bis(naphthalen-1-yl)-N,N'-bis(phenyl)benzidine and porphyrin compounds such as copper phthalocyanines. In addition, polymeric hole-injection materials can be used such as poly(N-vinylcarbazole) (PVK), polythiophenes, polypyrrole, polyaniline, self-doping polymers, such as, for example, sulfonated poly(thiophene-3-[2[(2-methoxyethoxy)ethoxy]-2,5-diyl) (Plexcore® OC Conducting Inks commercially available from Plextronics), and copolymers such as poly(3,4-ethylenedioxythiophene)/poly(4-styrenesulfonate) also called PEDOT/PSS.

In addition - in one embodiment - it is possible to use the inventive metal carbene complexes as hole conductor materials, in which case the band gap of the at least one hole conductor material is generally greater than the band gap of the emitter material used. In the context of the present application, band gap is understood to mean the triplet energy. Suitable carbene complexes are, for example, the inventive carbine complexes of the general formula (I), carbene complexes as described in WO2005/019373A2, WO2006/056418 A2, WO2005/113704, WO2007/115970, WO2007/115981 and WO2008/000727. One example of a suitable carbene complex is Ir(DPBIC)₃ with the formula:

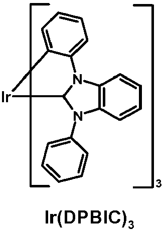

The hole-transporting layer may also be electronically doped in order to improve the transport properties of the materials used, in order firstly to make the layer thicknesses more generous (avoidance of pinholes/short circuits) and in order secondly to minimize the operating voltage of the device. Electronic doping is known to those skilled in the art and is disclosed, for example, in W. Gao, A. Kahn, J. Appl. Phys., Vol. 94, No. 1, 1 July 2003 (p-doped organic layers); A. G. Werner, F. Li, K. Harada, M. Pfeiffer, T. Fritz, K. Leo, Appl. Phys. Lett., Vol. 82, No. 25, 23 June 2003 and Pfeiffer et al., Organic Electronics 2003, 4, 89 - 103 and K. Walzer, B. Maennig, M. Pfeiffer, K. Leo, Chem. Soc. Rev. 2007, 107, 1233. For example it is possible to use mixtures in the hole-transporting layer, in particular mixtures which lead to electrical p-doping of the hole-transporting layer. p-Doping is achieved by the addition of oxidizing materials. These mixtures may, for example, be the following mixtures: mixtures of the abovementioned hole transport materials with at least one metal oxide, for example MoO₂, MoO₃, WOₓ, ReO₃ and/or V₂O₅, preferably MoO₃ and/or ReO₃, more preferably ReO₃ or mixtures comprising the aforementioned hole transport materials and one or more compounds selected from 7,7,8,8-tetracyanoquinodimethane (TCNQ), 2,3,5,6-tetrafluoro-7,7,8,8-tetracyanoquinodimethane (F₄-TCNQ), 2,5-bis(2-hydroxyethoxy)-7,7,8,8-tetracyanoquinodimethane, bis(tetra-n-butylammonium)tetracyanodiphenoquinodimethane, 2,5-dimethyl-7,7,8,8-tetracyanoquinodimethane, tetracyanoethylene, 11,11,12,12-tetracyanonaphtho2,6-quinodimethane, 2-fluoro-7,7,8,8-tetracyanoquino-dimethane, 2,5-difluoro-7,7,8,8-etracyanoquinodimethane, dicyanomethylene-1,3,4,5,7,8-hexafluoro-6Hnaphthalen-2-ylidene)malononitrile (F₆-TNAP), Mo(tfd)₃ (from Kahn et al., J. Am. Chem. Soc. 2009, 131 (35), 12530-12531), compounds as described in EP1988587 and in EP2180029 and quinone compounds as mentioned in EP2401254.

Suitable electron-transporting materials for layer (4) of the inventive OLEDs comprise metals chelated with oxinoid compounds, such as tris(8-hydroxyquinolato)aluminum (Alq₃), compounds based on phenanthroline such as 2,9-dimethyl-4,7-diphenyl-1,10-phenanthroline (DDPA = BCP), 4,7-diphenyl-1,10-phenanthroline (Bphen), 2,4,7,9-tetraphenyl-1,10-phenanthroline, 4,7-diphenyl-1,10-phenanthroline (DPA) or phenanthroline derivatives disclosed in EP1786050, in EP1970371, or in EP1097981, and azole compounds such as 2-(4-biphenylyl)-5-(4-t-butylphenyl)-1,3,4-oxadiazole (PBD) and 3-(4-biphenylyl)-4phenyl-5-(4-t-butylphenyl)-1,2,4-triazole (TAZ). Layer (4) may serve both to ease the electron transport and as a buffer layer or as a barrier layer in order to prevent quenching of the exciton at the interfaces of the layers of the OLED. Layer (4) preferably improves the mobility of the electrons and reduces quenching of the exciton.

It is likewise possible to use mixtures of at least two materials in the electron-transporting layer, in which case at least one material is electron-conducting. Preferably, in such mixed electron-transporting layers, at least one phenanthroline compound is used, preferably BCP, or at least one pyridine compound according to the formula **(VIII)** below, preferably a compound of the formula **(VIIIaa)** below. More preferably, in mixed electron-transporting layers, in addition to at least one phenanthroline compound, alkaline earth metal or alkali metal hydroxyquinolate complexes, for example Liq, are used. Suitable alkaline earth metal or alkali metal hydroxyquinolate complexes are specified below **(formula VII).** Reference is made to WO2011/157779.

The electron-transporting layer may also be electronically doped in order to improve the transport properties of the materials used, in order firstly to make the layer thicknesses more generous (avoidance of pinholes/short circuits) and in order secondly to minimize the operating voltage of the device. Electronic doping is known to those skilled in the art and is disclosed, for example, in W. Gao, A. Kahn, J. Appl. Phys., Vol. 94, No. 1, 1 July 2003 (p-doped organic layers); A. G. Werner, F. Li, K. Harada, M. Pfeiffer, T. Fritz, K. Leo, Appl. Phys. Lett., Vol. 82, No. 25, 23 June 2003 and Pfeiffer et al., Organic Electronics 2003, 4, 89 - 103 and K. Walzer, B. Maennig, M. Pfeiffer, K. Leo, Chem. Soc. Rev. 2007, 107, 1233. For example, it is possible to use mixtures which lead to electrical n-doping of the electron-transporting layer. n-Doping is achieved by the addition of reducing materials. These mixtures may, for example, be mixtures of the abovementioned electron transport materials with alkali/alkaline earth metals or alkali/alkaline earth metal salts, for example Li, Cs, Ca, Sr, Cs₂CO₃, with alkali metal complexes, for example 8-hydroxyquinolatolithium (Liq), and with Y, Ce, Sm, Gd, Tb, Er, Tm, Yb, Li₃N, Rb₂CO₃, dipotassium phthalate, W(hpp)₄ from EP 1786050, or with compounds as described in EP1837926B1.

The present invention therefore also relates to an inventive OLED which comprises an electron-transporting layer comprising at least two different materials, of which at least one material is electron-conducting.

In a preferred embodiment, the electron-transporting layer comprises at least one compound of the general formula (**VII**) 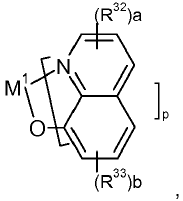 in which
R³² and R³³ are each independently F, C₁-C₈-alkyl, or C₆-C₁₄-aryl, which is optionally substituted by one or more C₁-C₈-alkyl groups, or
two R³² and/or R³³ substituents together form a fused benzene ring which is optionally substituted by one or more C₁-C₈-alkyl groups;
a and b are each independently 0, or 1, 2 or 3,
M¹ is an alkaline metal atom or alkaline earth metal atom,
p is 1 when M¹ is an alkali metal atom, p is 2 when M¹ is an earth alkali metal atom.

A very particularly preferred compound of the formula (VII) is 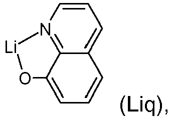 which may be present as a single species, or in other forms such as Li_{g}Q_{g} in which g is an integer, for example Li₆Q₆. Q is an 8-hydroxyquinolate ligand or an 8-hydroxyquinolate derivative.

In a further preferred embodiment, the electron-transporting layer comprises at least one compound of the formula (**VIII**), 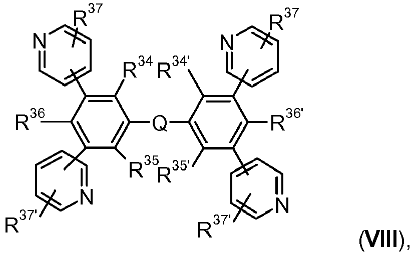 in which
R³⁴, R³⁵, R³⁶, R³⁷, R^{34'}, R^{35'}, R^{36'} and R^{37'} are each independently H, C₁-C₁₈-alkyl, C₁-C₁₈-alkyl which is substituted by E and/or interrupted by D, C₆-C₂₄-aryl, C₆-C₂₄-aryl which is substituted by G, C₂-C₂₀-heteroaryl or C₂-C₂₀-heteroaryl which is substituted by G,
Q is an arylene or heteroarylene group, each of which is optionally substituted by G;
D is -CO-; -COO-; -S-; -SO-; -SO₂-; -O-; -NR⁴⁰-; -SiR⁴⁵R⁴⁶-; -POR⁴⁷-; -CR³⁸=CR³⁹-; or -C≡C-;
E is -OR⁴⁴; -SR⁴⁴; -NR⁴⁰R⁴¹; -COR⁴³; -COOR⁴²; -CONR⁴⁰R⁴¹; -CN; or F;
G is E, C₁-C₁₈-alkyl, C₁-C₁₈-alkyl which is interrupted by D , C₁-C₁₈-perfluoroalkyl, C₁-C₁₈-alkoxy, or C₁-C₁₈-alkoxy which is substituted by E and/or interrupted by D,
   in which
R³⁸ and R³⁹ are each independently H, C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-;
R⁴⁰ and R⁴¹ are each independently C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-; or
   R⁴⁰ and R⁴¹ together form a 6-membered ring;
R⁴² and R⁴³ are each independently C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-,
R⁴⁴ is C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-,
R⁴⁵ and R⁴⁶ are each independently C₁-C₁₈-alkyl, C₆-C₁₈-aryl or C₆-C₁₈-aryl which is substituted by C₁-C₁₈-alkyl,
R⁴⁷ is C₁-C₁₈-alkyl, C₆-C₁₈-aryl or C₆-C₁₈-aryl which is substituted by C₁-C₁₈-alkyl.

Preferred compounds of the formula **(VIII)** are compounds of the formula **(VIIIa)** 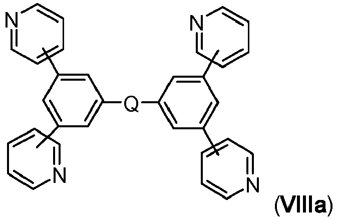
in which Q is: 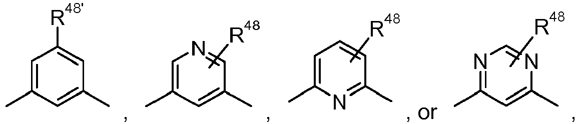
R⁴⁸ is H or C₁-C₁₈-alkyl and
R^{48'} is H, C₁-C₁₈-alkyl or

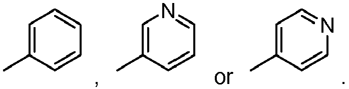

Particular preference is given to a compound of the formula **(VIIIaa)**

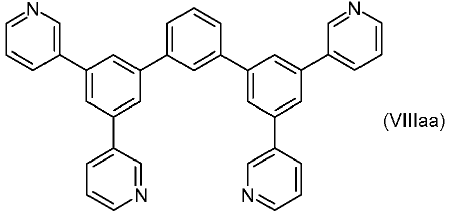

In a further, very particularly preferred embodiment, the electron-transporting layer comprises a compound of the formula 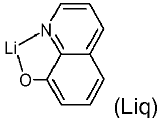 and a compound of the formula

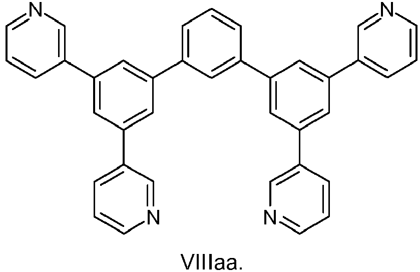

In a preferred embodiment, the electron-transporting layer comprises the compound of the formula (VII) in an amount of 99 to 1% by weight, preferably 75 to 25% by weight, more preferably about 50% by weight, where the amount of the compounds of the formulae (**VII**) and the amount of the compounds of the formulae **(VIII)** adds up to a total of 100% by weight.

The preparation of the compounds of the formula **(VIII)** is described in J. Kido et al., Chem. Commun. (2008) 5821-5823, J. Kido et al., Chem. Mater. 20 (2008) 5951-5953 and JP2008-127326, or the compounds can be prepared analogously to the processes disclosed in the aforementioned documents.

It is likewise possible to use mixtures of alkali metal hydroxyquinolate complexes, preferably Liq, and dibenzofuran compounds in the electron-transporting layer. Reference is made to WO2011/157790. Dibenzofuran compounds **A-1** to **A-36** and **B-1** to **B-22** described in WO2011/157790 are preferred, wherein dibenzofuran compound 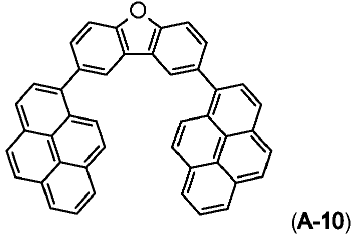 is most preferred.

In a preferred embodiment, the electron-transporting layer comprises Liq in an amount of 99 to 1% by weight, preferably 75 to 25% by weight, more preferably about 50% by weight, where the amount of Liq and the amount of the dibenzofuran compound(s), especially 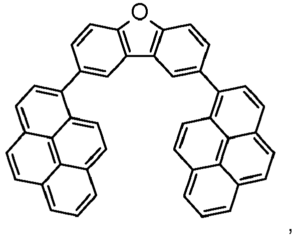 adds up to a total of 100% by weight.

In a preferred embodiment, the invention relates to an inventive OLED wherein the electron-transporting layer comprises at least one phenanthroline derivative and/or pyridine derivative.

In a further preferred embodiment, the invention relates to an inventive OLED wherein the electron-transporting layer comprises at least one phenanthroline derivative and/or pyridine derivative and at least one alkali metal hydroxyquinolate complex.

In a further preferred embodiment, the invention relates to an inventive OLED wherein the electron-transporting layer comprises at least one phenanthroline derivative and/or pyridine derivative and 8-hydroxyquinolatolithium.

Some of the materials mentioned above as hole transport materials and electron-transporting materials can fulfill several functions. For example, some of the electron-transporting materials are simultaneously hole-blocking materials if they have a low-lying HOMO.

The cathode (5) is an electrode which serves to introduce electrons or negative charge carriers. The cathode may be any metal or nonmetal which has a lower work function than the anode. Suitable materials for the cathode are selected from the group consisting of alkali metals of group 1, for example Li, Cs, alkaline earth metals of group 2, metals of group 12 of the Periodic Table of the Elements, comprising the rare earth metals and the lanthanides and actinides. In addition, metals such as aluminum, indium, calcium, barium, samarium and magnesium, and combinations thereof, may be used. In addition, lithium-comprising organometallic compounds such as 8-hydroxyquinolatolithium (Liq), CsF, NaF, KF, Cs₂CO₃ or LiF may be applied between the organic layer and the cathode as an electron injection layer in order to reduce the operating voltage.

The OLED of the present invention may additionally comprise further layers which are known to those skilled in the art. For example, a layer which eases the transport of the positive charge and/or matches the band gaps of the layers to one another may be applied between the layer (2) and the light-emitting layer (3). Alternatively, this further layer may serve as a protective layer. In an analogous manner, additional layers may be present between the light-emitting layer (3) and the layer (4) in order to ease the transport of the negative charge and/or to match the band gaps between the layers to one another. Alternatively, this layer may serve as a protective layer.

In a preferred embodiment, the inventive OLED, in addition to the layers (1) to (5), comprises at least one of the further layers mentioned below:
- a hole injection layer between the anode (1) and the hole-transporting layer (2);
- a blocking layer for electrons between the hole-transporting layer (2) and the light-emitting layer (3);
- a blocking layer for holes between the light-emitting layer (3) and the electron-transporting layer (4);
- an electron injection layer between the electron-transporting layer (4) and the cathode (5).

As already mentioned above, however, it is also possible that the OLED does not have all of the layers (1) to (5) mentioned; for example, an OLED comprising layers (1) (anode), (3) (light-emitting layer) and (5) (cathode) is likewise suitable, in which case the functions of layers (2) (hole-transporting layer) and (4) (electron-transporting layer) are assumed by the adjoining layers. OLEDs having layers (1), (2), (3) and (5) or layers (1), (3), (4) and (5) are likewise suitable.

Those skilled in the art know how suitable materials have to be selected (for example on the basis of electrochemical investigations). Suitable materials for the individual layers are known to those skilled in the art and disclosed, for example, in WO00/70655.

In addition, it is possible that some or all of the layers (1), (2), (3), (4) and (5) have been surface-treated in order to increase the efficiency of charge carrier transport. The selection of the materials for each of the layers mentioned is preferably determined by obtaining an OLED having a high efficiency.

The inventive OLED can be produced by methods known to those skilled in the art. In general, the OLED is produced by successive vapor deposition of the individual layers onto a suitable substrate. Suitable substrates are, for example, glass, inorganic materials such as ITO or IZO or polymer films. For the vapor deposition, customary techniques may be used, such as thermal evaporation, chemical vapor deposition (CVD), physical vapor deposition (PVD) and others.

In an alternative process, the organic layers may be coated from solutions or dispersions in suitable solvents, in which case coating techniques known to those skilled in the art are employed. Suitable coating techniques are, for example, spin-coating, the casting method, the Langmuir-Blodgett ("LB") method, the inkjet printing method, dip-coating, letterpress printing, screen printing, doctor blade printing, slit-coating, roller printing, reverse roller printing, offset lithography printing, flexographic printing, web printing, spray coating, coating by a brush or pad printing, and the like. Among the processes mentioned, in addition to the aforementioned vapor deposition, preference is given to spin-coating, the inkjet printing method and the casting method since they are particularly simple and inexpensive to perform. In the case that layers of the OLED are obtained by the spin-coating method, the casting method or the inkjet printing method, the coating can be obtained using a solution prepared by dissolving the composition in a concentration of 0.0001 to 90% by weight in a suitable organic solvent such as benzene, toluene, xylene, tetrahydrofuran, methyltetrahydrofuran, N,N-dimethylformamide, acetone, acetonitrile, anisole, dichloromethane, dimethyl sulfoxide, water and mixtures thereof.

It is possible that the layers of the OLED are all produced by the same coating method. Furthermore, it is likewise possible to conduct two or more different coating methods to produce the layers of the OLED.

In general, the different layers have the following thicknesses: anode (2) 500 to 5000 Å, preferably 1000 to 2000 Å (ångström); hole-transporting layer (3) 50 to 1000 Å, preferably 200 to 800 Å; light-emitting layer (4) 10 to 1000 Å, preferably 100 to 800 Å; electron-transporting layer (5) 50 to 1000 Å, preferably 200 to 800 Å; cathode (6) 200 to 10 000 Å, preferably 300 to 5000 Å. In addition, it is likewise possible to combine several layers by mixing. For example, the hole-transporting material can be mixed with the materials of the light-emitting layer and then applied together. The position of the recombination zone of holes and electrons in the inventive OLED and thus the emission spectrum of the OLED may be influenced by the relative thickness and concentration ratios of each layer. This means that the thickness of the electron transport layer should preferably be selected such that the electron/hole recombination zone is within the light-emitting layer. The ratio of the layer thicknesses of the individual layers in the OLED is dependent upon the materials used. The layer thicknesses of any additional layers used are known to those skilled in the art.

In a preferred embodiment, the present invention relates to an OLED comprising at least one inventive metal-carbene complex, and at least one compound of the general formula 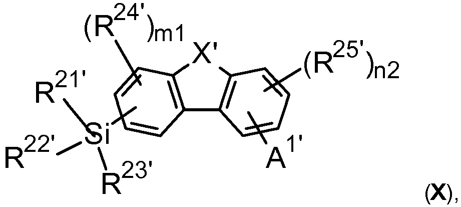 wherein
X' is NR, S, O or PR^{26'};
R^{26'} is aryl, heteroaryl, alkyl, cycloalkyl, or heterocycloalkyl;
A^{1'} is -NR^{6'}R^{7'}, -P(O)R^{3'}R^{9'}, -PR^{10'}R^{11'}, -S(O)₂R^{12'}, -S(O)R^{13'}, -SR^{14'}, or -OR^{15'};
R^{21'}, R^{22'} and R^{23'} are independently of each other aryl, heteroaryl, alkyl, cycloalkyl, or heterocycloalkyl, wherein at least on of the groups R^{21'}, R^{22'}, or R^{23'} is aryl, or heteroaryl;
R^{24'} and R^{25'} are independently of each other alkyl, cycloalkyl, heterocycloalkyl, aryl, heteroaryl, a group A^{1'}, or a group having donor, or acceptor characteristics;
n2 and m1 are independently of each other 0, 1, 2, or 3;
R^{6'} and R^{7'} form together with the nitrogen atom a cyclic residue having 3 to 10 ring atoms, which can be unsubstituted, or which can be substituted with one, or more substituents selected from alkyl, cycloalkyl, heterocycloalkyl, aryl, heteroaryl and a group having donor, or acceptor characteristics; and/or which can be annulated with one, or more further cyclic residues having 3 to 10 ring atoms, wherein the annulated residues can be unsubstituted, or can be substituted with one, or more substituents selected from alkyl, cycloalkyl, heterocycloalkyl, aryl, heteroaryl and a group having donor, or acceptor characteristics; and R^{8'}, R^{9'}, R^{10'}, R^{11'}, R^{12'}, R^{13'}, R^{14'} und R^{15'} are independently of each other aryl, heteroaryl, alkyl, cycloalkyl, or heterocycloalkyl. Compounds of formula **X**, such as, for example, 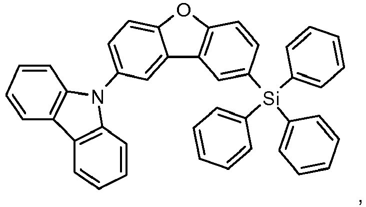 or 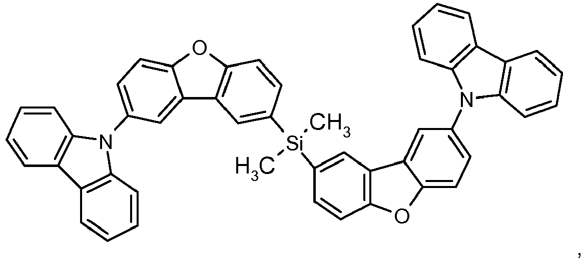 are described in WO2010079051 (in particular pages on 19 to 26 and in tables on pages 27 to 34, pages 35 to 37 and pages 42 to 43).

Additional matrix materials on basis of dibenzofurane are, for example, described in US2009066226, EP1885818B1, EP1970976, EP1998388 and EP2034538. Examples of particularly preferred matrix materials are shown below:

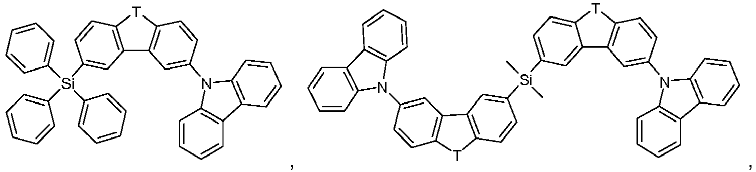

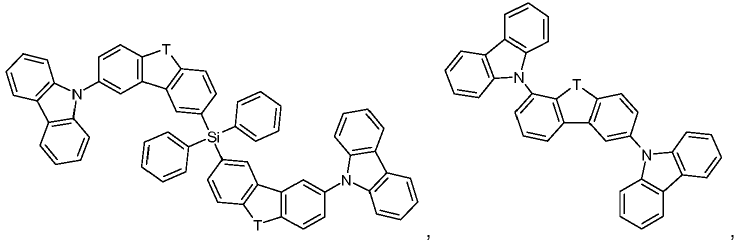

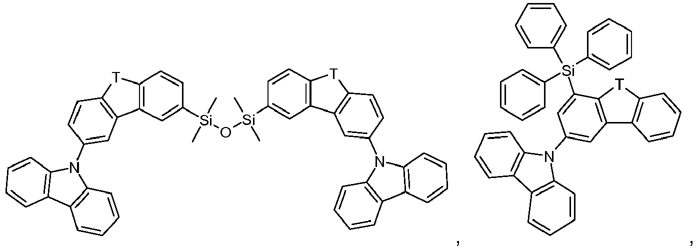

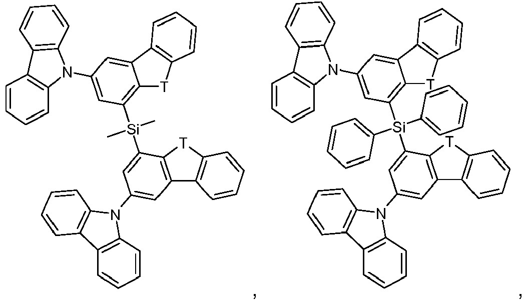

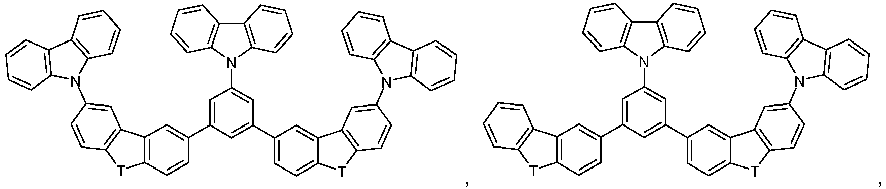

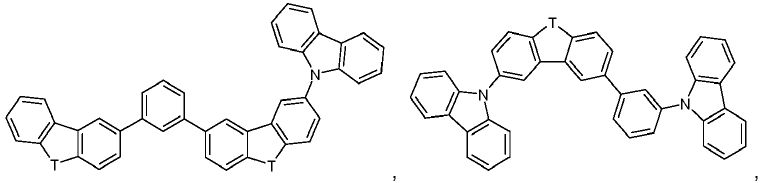

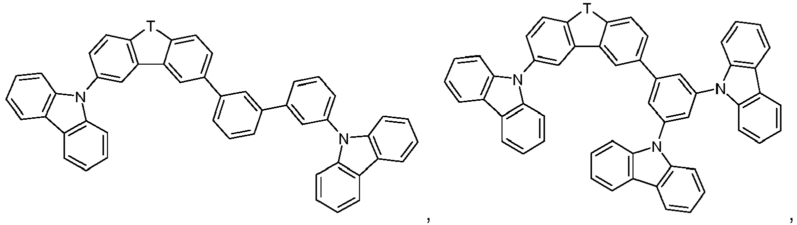

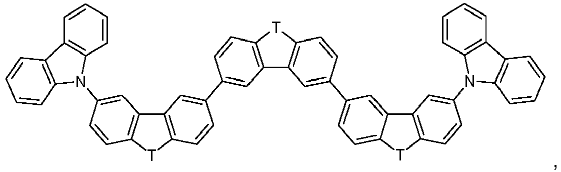

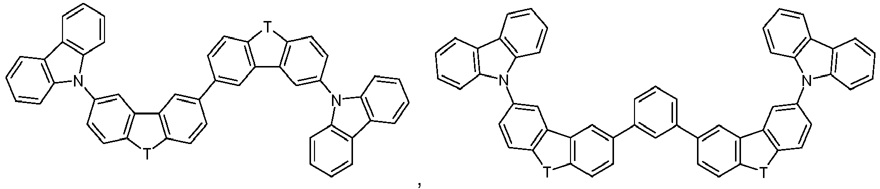

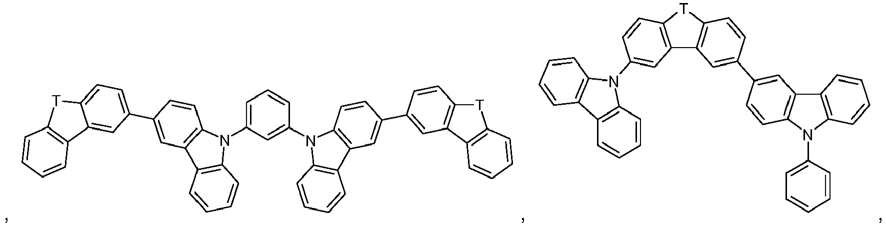

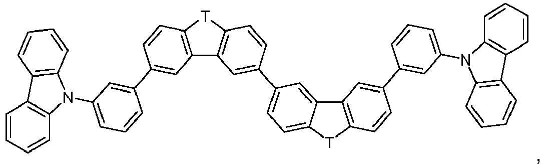

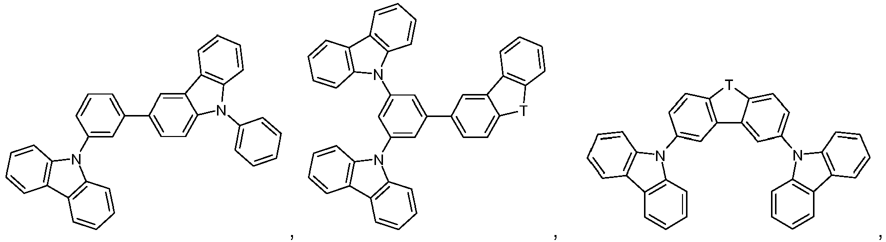

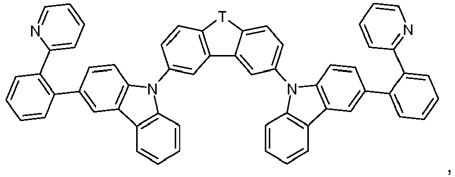

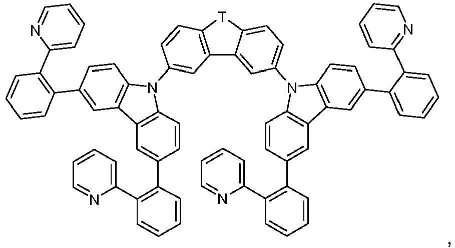

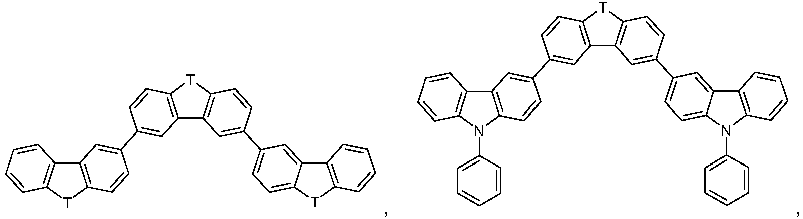

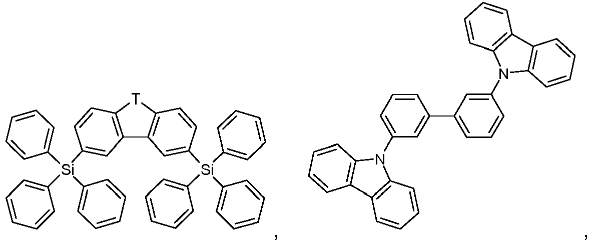

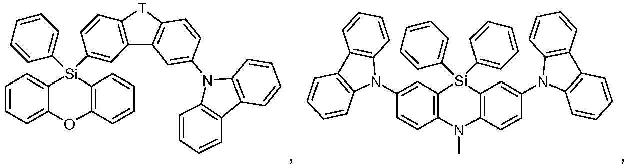

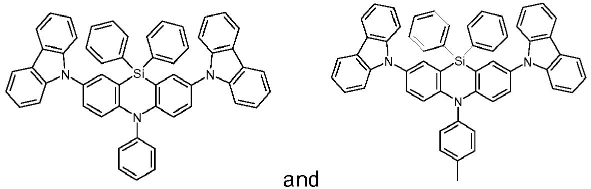

In the above-mentioned compounds T is O, or S, preferably O. If T occurs more than one time in a molecule, all groups T have the same meaning.

In a preferred embodiment, the light-emitting layer is formed from 2 to 40% by weight, preferably 5 to 35% by weight, of at least one of the inventive metal carben complexes and 60 to 98% by weight, preferably 65 to 95% by weight, of at least one of the aforementioned matrix materials, where the sum total of the emitter material and of the matrix material adds up to 100% by weight.

In particularly preferred embodiment, the light-emitting layer comprises a matrix material, such as, for example, 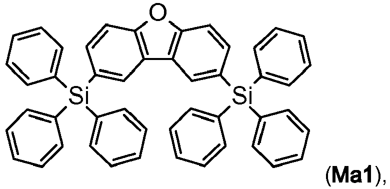 and two carbene complexes, preferably of formula

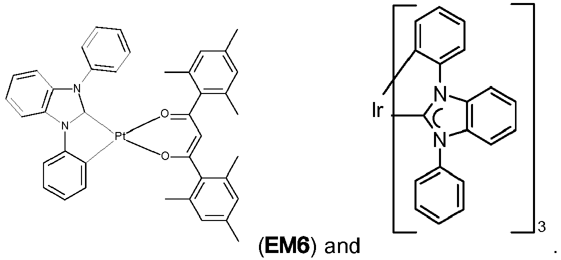

In said embodiment, the light-emitting layer is formed from 2 to 40% by weight, preferably 5 to 35% by weight, of **EM6** and 60 to 98% by weight, preferably 65 to 95% by weight, of **Ma1** and 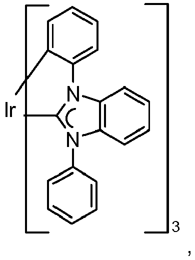 where the sum total of the carben complexes and **Ma1** adds up to 100% by weight.

Suitable metal complexes for use as matrix material and/or hole/exciton blocker material and/or electron/exciton blocker material and/or hole injection material and/or electron injection material and/or hole transport material and/or electron transport material, preferably as matrix material and/or hole/exciton blocker material, in OLEDs are thus, for example, also carbene complexes as described in WO 2005/019373 A2, WO 2006/056418 A2, WO 2005/113704, WO 2007/115970, WO 2007/115981 and WO 2008/000727. Explicit reference is made here to the disclosure of the WO applications cited, and these disclosures shall be considered to be incorporated into the content of the present application.

In addition to the compounds of the formula (**X**), according to the present invention, it is also possible to use crosslinked or polymeric materials comprising repeat units based on the general formula (**X**) in crosslinked or polymerized form together with at least one inventive metal-carbene complex. Like the compounds of the general formula (**X**), the latter are preferably used as matrix materials.

The crosslinked or polymeric materials have outstanding solubility in organic solvents, excellent film-forming properties and relatively high glass transition temperatures. In addition, high charge carrier mobilities, high stabilities of color emission and long operating times of the corresponding components can be observed when crosslinked or polymeric materials according to the present invention are used in organic light-emitting diodes (OLEDs).

The crosslinked or polymerized materials are particularly suitable as coatings or in thin films since they are thermally and mechanically stable and relatively defect-free.

The crosslinked or polymerized materials comprising repeating units based on the general formula (**X**) can be prepared by a process comprising steps (a) and (b):
(a) preparation of a crosslinkable or polymerizable compound of the general formula (**X**) where at least one of the m1 R²⁴ radicals or at least one of the n2 R²⁵ radicals is a crosslinkable or polymerizable group attached via a spacer, and
(b) crosslinking or polymerization of the compound of the general formula (**X**) obtained from step (a).

The crosslinked or polymerized materials may be homopolymers, which means that exclusively units of the general formula (**X**) are present in crosslinked or polymerized form. They may also be copolymers, which means that further monomers are present in addition to the units of the general formula (**X**), for example monomers with hole-conducting and/or electron-conducting properties, in crosslinked or polymerized form.

In a further preferred embodiment of the inventive OLED, it comprises an emission layer comprising at least one inventive metal-carbene complex, at least one matrix material of the formula (**X**), and optionally at least one further hole-transporting matrix material.

The inventive OLEDs can be used in all devices in which electroluminescence is useful. Suitable devices are preferably selected from stationary and mobile visual display units and illumination means. The present invention therefore also relates to a device selected from the group consisting of stationary visual display units and mobile visual display units and illumination means, comprising an inventive OLED.

Stationary visual display units are, for example, visual display units of computers, televisions, visual display units in printers, kitchen appliances and advertising panels, illuminations and information panels. Mobile visual display units are, for example, visual display units in cellphones, laptops, tablet PCs, digital cameras, mp-3 players, smartphones, vehicles, and destination displays on buses and trains.

The inventive metal-carbene complexes can additionally be used in OLEDs with inverse structure. In these inverse OLEDs, the inventive complexes are in turn preferably used in the light-emitting layer. The structure of inverse OLEDs and the materials typically used therein are known to those skilled in the art.

The present invention further provides a white OLED comprising at least one inventive metal-carbene complex. In a preferred embodiment, the inventive metal-carbene complexes are used as emitter material in the white OLED. Preferred embodiments of the inventive metal-carbene complexes have been specified above. In addition to the at least one inventive metal-carbene complex, the white OLED may comprise
(i) at least one compound of the formula (**X**). The compound of the formula (**X**) is preferably used as matrix material. Preferred compounds of the formula (**X**) have been specified above; and/or
(ii) at least one compound of the formula (**VII**) and/or (**IX**). The compounds of the formula (**VII**) and/or (**IX**) are preferably used as electron transport material. Preferred compounds of the formulae (**VII**) and (**IX**) have been specified above.

In order to obtain white light, the OLED must generate light which colors the entire visible range of the spectrum. However, organic emitters normally emit only in a limited portion of the visible spectrum - i.e. are colored. White light can be generated by the combination of different emitters. Typically, red, green and blue emitters are combined. However, the prior art also discloses other methods for formation of white OLEDs, for example the triplet harvesting approach. Suitable structures for white OLEDs or methods for formation of white OLEDs are known to those skilled in the art.

In one embodiment of a white OLED, several dyes are layered one on top of another in the light-emitting layer of an OLED and hence combined (layered device). This can be achieved by mixing all dyes or by direct series connection of different-colored layers. The expression "layered OLED" and suitable embodiments are known to those skilled in the art.

In general, the different layers then have the following thicknesses: anode (2) 500 to 5000 Å (ångström), preferably 1000 to 2000 Å; hole-transporting layer (3) 50 to 1000 Å, preferably 200 to 800 Å, either a light-emitting layer comprising a mixture of different emitters (4): 10 to 1000 Å, preferably 100 to 800 Å, or several light-emitting layers in succession, each individual layer comprising a different emitter (4a, b, c, ...): each 10 to 1000 Å, preferably each 50 to 600 Å, electron-transporting layer (5) 50 to 1000 Å, preferably 200 to 800 Å, cathode (6) 200 to 10 000 Å, preferably 300 to 5000 Å.

In a further embodiment of a white OLED, several different-colored OLEDs are stacked one on top of another (stacked device). For the stacking of two OLEDs, what is called a charge generation layer (CG layer) is used. This CG layer may be formed, for example, from one electrically n-doped and one electrically p-doped transport layer. The expression "stacked OLED" and suitable embodiments are known to those skilled in the art.

In general, the different layers then have the following thicknesses: anode (2) 500 to 5000 Å (ångström), preferably 1000 to 2000 Å; first hole-transporting layer (3) 50 to 1000 Å, preferably 200 to 800 Å, first light-emitting layer (4) 10 to 1000 Å, preferably 50 to 600 Å, first electron-transporting layer (5) 50 to 1000 Å, preferably 200 to 800 Å, electrically n-doped layer 50 to 1000 Å, preferably 100 to 800 Å, electrically p-doped layer 50 to 1000 Å, preferably 100 to 800 Å, second hole-transporting layer (3) to 50 to 1000 Å, preferably 200 to 800 Å, second light-emiting layer (4) 10 to 1000 Å, preferably 50 to 600 Å, second electron-transporting layer (5) 50 to 1000 Å, preferably 200 to 800 Å, electrically n-doped layer 50 to 1000 Å, preferably 100 to 800 Å, electrically p-doped layer 50 to 1000 Å, preferably 100 to 800 Å, third hole-transporting layer (3) to to 1000 Å, preferably 200 to 800 Å, third light-emitting layer (4) 10 to 1000 Å, preferably 50 to 600 Å, third electron-transporting layer (5) to 50 to 1000 Å, preferably 200 to 800 Å, cathode (6) 200 to 10 000 Å, preferably 300 to 5000 Å.

In further embodiments of this "stacked device concept", it is also possible to stack only two OLEDs or to stack more than three OLEDs.

In a further embodiment of white OLEDs, the two concepts mentioned for white light generation can also be combined. For example, a single-color OLED (for example blue) can be stacked with a multicolor layered OLED (for example red-green). Further combinations of the two concepts are conceivable and known to those skilled in the art.

The inventive metal-carbene complexes can be used in any of the layers mentioned above in white OLEDs. In a preferred embodiment, it is used in one or more or all light-emitting layer(s) of the OLED(s), in which case the structure of the invention metal-carbene complex is varied as a function of the use of the complex. Suitable and preferred components for the further layers of the OLED(s) are materials suitable as matrix material in the light-emitting layer(s) and preferred matrix materials are likewise specified above.

The present invention also relates to an organic electronic component, preferably an organic light-emitting diode (OLED), organic photovoltaic cell (OPV), organic field-effect transistor (OFET) or light-emitting electrochemical cell (LEEC), comprising at least one inventive metal-carbene complex.

### Examples

The examples which follow, more particularly the methods, materials, conditions, process parameters, apparatus and the like detailed in the examples, are intended to support the present invention, but not to restrict the scope of the present invention. All experiments are carried out in protective gas atmosphere. The percentages and ratios mentioned in the examples below - unless stated otherwise - are % by weight and weight ratios.

### Carbene precursor synthesis

The synthesis of suitable carbene ligand precursors is well documented in literature. Procedures can be found e.g. in Enders et al. (Helvetica Chimica Acta 1996, 79, 61-83), Bielawski et al. (Inorg. Chem. 2009, 48, 6924-6933), US provisional application 61/496646, and WO2005019373.

### General procedure for the complexation

0.8 mmol of the imidazolium salt and 93 mg (0.4 mmol) silver(I) oxide are dissolved in 20 mL dry 1,4-dioxane and stirred for 21 h at room temperature under an argon atmosphere. After addition of 10 mL 2-butanone and 299 mg (0.8 mmol) dichloro(1,5-cyclooctadiene)platinum the reaction mixture is heated and refluxed for 21 h. The solvent is removed and the residue dissolved in 20 mL dry DMF. A 3.2 mmol amount of the diketone and 359 mg (3.2 mmol) of potassium-tert-butanolate are added. The mixture is then stirred for 21 h at room temperature and another 6 h at 100 °C under argon. After filtration the solvent is removed under reduced pressure and the residue washed with water, followed by column chromatography (silica gel KG60) with dichloromethane as eluent.

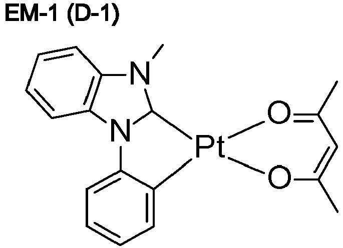

Following the general procedure described above 269 mg of 1-phenyl-3-methyl-1*H-*benzo[*d*]imidazolium iodide and 0.33 ml of acetylacetone were used to obtain 209 mg (0.42 mmol) of the complex (52%). ¹H-NMR (CDCl₃, 300.13 MHz): δ = 7.90 (d, *pseudo*-t, *J* = 7.5 Hz, *J*_{H,Pt} = 30.4 Hz, 2H, CH_{arom.}), 7.76 (d, *J* = 7.8 Hz, 1H, CH_{arom.}), 7.35 (m, 3H, CH_{arom.}), 7.13 (dt, *J* = 1.3 Hz, *J* = 7.6 Hz, 1H, CH_{arom.}), 7.03 (dt, *J* = 1.1 Hz, *J* = 7.4 Hz, 1H, CH_{arom.}), 5.52 (s, 1H, CH), 4.26 (s, 3H, CH₃), 2.08 (s, 3H, CH₃), 2.01 (s, 3H, CH₃) ppm. ¹³C-NMR (CDCl₃, 75 MHz): δ = 185.2 (OCCH₃), 160.7 (Cᵢ), 148.1 (Cᵢ), 135.6 (Cᵢ), 131.3 (Cᵢ), 131.2 (C_{arom.}H), 125.3 (Cᵢ), 124.1 (C_{arom.}H), 123.7 (C_{arom.}H), 123.4 (C_{arom.}H), 122.7 (C_{arom.}H), 111.4 (C_{arom.}H), 110.8 (C_{arom.}H), 110.4 (C_{arom.}H), 102.0 (CH), 31.2 (NCH₃), 28.0 (CH₃), 27.9 (CH₃) ppm. M.p.: 177-179 °C. Anal. Calc. for C₁₉H₁₈N₂O₂Pt (501.44 g mol⁻¹): C: 45.51; H: 3.62; N: 5.59. Found: C: 45.48; H: 3.74; N: 5.62 %.

Photoluminescence (2% in PMMA matrix): λₘₐₓ = 454 nm, CIE: (0.20;0.24); QY = 40%.

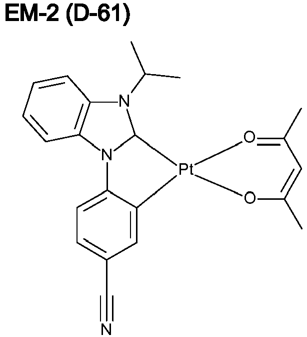

Following the general procedure described above 279 mg of 1-(4-cyanophenyl)-3-isopropyl-1*H*-benzo[*d*]imidazolium tetrafluoroborate and 0.33 ml of acetylacetone were used to obtain 133 mg (0.24 mmol) of the complex (30%). ¹H-NMR (CDCl₃, 300.13 MHz): δ = 8.18 (d, *pseudo*-t, *J* = 1.7 Hz, *J*_{H,Pt} = 28.6 Hz, 1H, PtCCH_{arom.}), 7.95 (d, *J* = 7.6 Hz, 1H, CH_{arom.}), 7.70 (d, *J* = 7.3 Hz, 1H, CH_{arom.}), 7.54 (d, *J* = 8.2 Hz, 1H, CH_{arom.}), 7.46 (dd, *J* = 1.8 Hz, *J* = 8.2 Hz, 1H, CH_{arom.}), 7.41 (dt, *J* = 1.3 Hz, *J* = 7.5 Hz, 1H, CH_{arom.}), 7.34 (dt, *J* = 1.1 Hz, *J* = 7.5 Hz, 1H, CH_{arom.}), 6.48 (sept, *J* = 7.0 Hz, 1H, CH₃CH), 5.59 (s, 1H, OCCH), 2.13 (s, 3H, CH₃), 2.03 (s, 3H, CH₃), 1.75 (s, 3H, CH₃), 1.73 (s, 3H, CH₃) ppm. ¹³C-NMR (CDCl₃, 75.5 MHz): δ = 185.9 (OC), 185.4 (OC), 159.9 (Cᵢ), 151.6 (Cᵢ), 134.2 (CH_{arom.}), 133.1 (Cᵢ), 132.2 (Cᵢ), 128.8 (CH_{arom.}), 126.8 (Cᵢ), 124.3 (CH_{arom.}), 123.1 (CH_{arom.}), 120.1 (Cᵢ), 113.7 (CH_{arom.}), 111.3 (CH_{arom.}), 111.2 (CH_{arom.}), 106.2 (Cᵢ), 102.3 (CH), 49.5 (CH₃CH), 27.9 (CH₃), 27.8 (CH₃), 21.3 (CH₃), 21.1 (CH₃) ppm. Anal. Calc. for C₂₂H₂₁N₃O₂Pt (554.51 g mol⁻¹): C: 47.65; H: 3.82; N: 7.58.

Photoluminescence (2% in PMMA matrix): λₘₐₓ = 444 nm, CIE: (0.16;0.16); QY = 63%

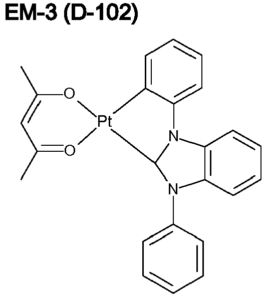

Following the general procedure described above 287 mg of 1,3-diphenyl-1*H-*benzo[*d*]imidazolium tetrafluoroborate and 0.33 ml of acetylacetone were used to obtain 241 mg (0.43 mmol) of the complex (53%). ¹H-NMR (CDCl₃, 300.13 MHz): δ = 8.04 (d, *J* = 8.2 Hz, 1H, CH_{arom.}), 7.92 (dd, *pseudo*-t, *J* = 1.4 Hz, *J* = 7.4 Hz, *J*_{H,Pt} = 27.0 Hz, 1H, PtCCH_{arom.}), 7.57 (m, 6H, CH_{arom.}), 7.41 (t, *J* = 7.8 Hz, 1H, CH_{arom.}), 7.27 (t, *J* = 7.7 Hz, 1H, CH_{arom.}), 7.19 (dt, *J* = 1.4 Hz, *J* = 7.6 Hz, 1H, CH_{arom.}), 7.12 (d, *J* = 7.40 Hz, 1H, CH_{arom.}), 7.09 (dt, *J* = 1.4 Hz, *J* = 7.6 Hz, 1H, CH_{arom.}), 5.31 (s, 1H, CH), 2.01 (s, 3H, CH₃), 1.31 (s, 3H, CH₃) ppm. ¹³C-NMR (CDCl₃, 125.8 MHz): δ = 185.36 (OCCH₃), 184.09 (OCCH₃), 148.03 (Cᵢ), 136.52 (Cᵢ), 136.23 (Cᵢ), 131.49 (C_{arom.}H), 131.04 (Cᵢ), 129.18 (C_{arom.}H), 129.09 (C_{arom.}H), 128.42 (C_{arom.}H), 126.24 (Cᵢ), 124.48 (C_{arom.}H), 123.82 (C_{arom.}H), 123.75 (C_{arom.}H), 123.10 (C_{arom.}H), 111.81 (C_{arom.}H), 111.55 (C_{arom.}H), 110.93 (C_{arom.}H), 101.71 (CH), 27.56 (CH₃), 27.12 (CH₃) ppm. M.p.: 231-233 °C. Anal. Calc. for C₂₄H₂₀N₂O₂Pt (563.51 g mol⁻¹): C: 51.15; H: 3.58; N: 4.97. Found: C: 51.38; H: 3.63; N: 4.87 %.

Photoluminescence (2% in PMMA matrix): λₘₐₓ = 457 nm, CIE: (0.16;0.15); QY = 41%.

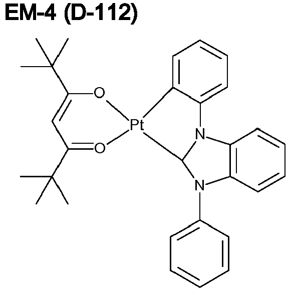

Following the general procedure described above 287 mg of 1,3-diphenyl-1*H-*benzo[*d*]imidazolium tetrafluoroborate and 0.67 ml of 2,2,6,6-Tetramethyl-3,5-heptanedione were used to obtain 210 mg (0.34 mmol) of the complex (40%). ¹H-NMR (CDCl₃, 300.13 MHz): δ = 8.05 (m, 2H, CH_{arom.}), 7.69 (m, 2H, CH_{arom.}), 7.60 (m, 3H, CH_{arom.}), 7.51 (m, 1H, CH_{arom.}), 7.40 (m, 1H, CH_{arom.}), 7.23 (d, *J* = 7.3 Hz, 1H, CH_{arom.}), 7.19 (dt, *J* = 1.9 Hz, *J* = 7.6 Hz, 1H, CH_{arom.}), 7.10 (dt, *J* = 1.2 Hz, *J* = 7.4 Hz, 1H, CH_{arom.}), 7.05 (d, *J* = 8.1 Hz, 1H, CH_{arom.}), 5.70 (s, 1H, CH), 1.27 (s, 9H, CH₃), 0.69 (s, 9H, CH₃) ppm. M.p.: 271-275 °C. Anal. Calc. for C₃₀H₃₂N₂O₂Pt (647.67 g mol⁻¹): C: 55.63; H: 4.98; N: 4.33. Found: C: 55.82; H: 4.86; N: 4.19 %.

Photoluminescence (2% in PMMA matrix): λₘₐₓ = 461 nm, CIE: (0.16;0.16); QY = 54%.

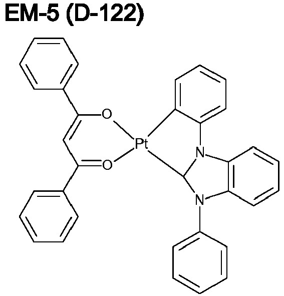

Following the general procedure described above 287 mg of 1,3-diphenyl-1*H-*benzo[*d*]imidazolium tetrafluoroborate and 732 mg of 1,3-Diphenyl-1,3-propandione were used to obtain 220 mg (0.32 mmol) of the complex (40%). ¹H-NMR (CDCl₃, 300.13 MHz): δ = 8.15 (dd, *pseudo*-t, *J* = 1.6 Hz, *J* = 7.2 Hz, *J*_{H,Pt} = 26.1 Hz, 1H, PtCCH_{arom.}), 8.10 (dd, *J* = 1.4 Hz, *J* = 8.0 Hz, 2H, CH_{arom.}), 8.05 (d, *J* = 8.2 Hz, 1H, CH_{arom.}), 7.73 (d, *J* = 7.9 Hz, 2H, CH_{arom.}), 7.64 (d, *J* = 7.6 Hz, 1H, CH_{arom.}), 7.46 (m, 8H, CH_{arom.}), 7.17 (m, 8H, CH_{arom.}), 6.66 (s, 1H, CH) ppm. ¹³C-NMR (CDCl₃, 75.5 MHz): δ = 180.4 (OCC), 178.9 (OCC), 160.7 (Cᵢ), 148.0 (Cᵢ), 139.9 (Cᵢ), 136.5 (Cᵢ), 136.2 (Cᵢ), 131.6 (C_{arom.}H), 131.1 (C_{arom.}H), 130.7 (C_{arom.}H), 130.3 (C_{arom.}H), 129.5 (C_{arom.}H), 129.4 (C_{arom.}H), 128.5 (C_{arom.}H), 128.0 (C_{arom.}H), 127.8 (C_{arom.}H), 127.2 (C_{arom.}H), 127.2 (C_{arom.}H), 125.9 (Cᵢ), 124.7 (C_{arom.}H), 124.0 (C_{arom.}H), 123.9 (C_{arom.}H), 123.2 (C_{arom.}H), 112.0 (C_{arom.}H), 111.7 (C_{arom.}H), 111.0 (C_{arom.}H), 96.8 (CH) ppm. M.p.: 234-236 °C. Anal. Calc. for C₃₄H₂₄N₂O₂Pt (687.66 g mol⁻¹): C: 59.39; H: 3.52; N: 4.07. Found: C: 59.30; H: 3.26; N: 4.07 %.

Photoluminescence (2% in PMMA matrix): λₘₐₓ = 520 nm, CIE: (0.30;0.56); QY = 78%.

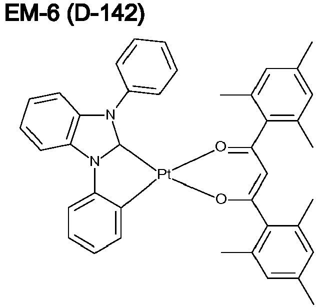

Following the general procedure described above 287 mg of 1,3-diphenyl-1*H-*benzo[*d*]imidazolium tetrafluoroborate and 987 mg of dimesitoylmethane were used to obtain 256 mg (0.33 mmol) of the complex (41%). ¹H-NMR (DMSO-*d*₆, 600.13 MHz): δ = 8.38 (d, *J* = 8.3 Hz, 1H, CH_{arom.}), 7.84 (d, *J* = 7.3 Hz, 1H, CH_{arom.}), 7.52 (dt, *J* = 1.3 Hz, *J* = 7.5 Hz, 1H, CH_{arom.}), 7.48 (dd, *J* = 1.0 Hz, *J* = 8.3 Hz, 3H, CH_{arom.}), 7.36 (t, *J* = 7.8 Hz, 1H, CH_{arom.}), 7.15 (dt, *J* = 1.4 Hz, *J* = 7.7 Hz, 1H, CH_{arom.}), 7.06 (d, *J* = 8.1 Hz, 1H, CH_{arom.}), 7.01 (t, *J* = 7.9 Hz, 2H, CH_{arom.}), 6.95 (dt, *J* = 0.9 Hz, *J* = 7.4 Hz, 1H, CH_{arom.}), 6.87 (s, 2H, CH_{arom.}), 6.78 (s, 2H, CH_{arom.}), 6.59 (t, *J* = 7.5 Hz, 1H, CH_{arom.}), 5.34 (s, 1H, CH), 2.30 (s, 3H, CH₃), 2.23 (s, 3H, CH₃), 2.21 (s, 6H, CH₃), 1.95 (s, 6H, CH₃) ppm. ¹³C-NMR (DMSO-*d*₆, 125.8 MHz): δ = 185.6 (OCC), 182.6 (OCC), 159.6 (Cᵢ), 147.4 (Cᵢ), 138.6 (Cᵢ), 138.5 (Cᵢ), 137.2 (Cᵢ), 136.3 (Cᵢ), 135.9 (Cᵢ), 134.7 (Cᵢ), 133.2 (Cᵢ), 132.2 (Cᵢ), 130.6 (C_{arom.}H), 129.9 (Cᵢ), 128.3 (C_{arom.}H), 128.1 (C_{arom.}H), 128.0 (C_{arom.}H), 127.3 (C_{arom.}H), 127.2 (C_{arom.}H), 126.2 (Cᵢ), 124.8 (C_{arom.}H), 124.0 (C_{arom.}H), 123.8 (C_{arom.}H), 123.4 (C_{arom.}H), 112.2 (C_{arom.}H), 111.5 (C_{arom.}H), 111.3 (C_{arom.}H), 105.6 (CH), 20.7 (CH₃), 20.6 (CH₃), 19.3 (CH₃), 18.6 (CH₃) ppm. M.p.: 236-238 °C. Anal. Calc. for C₄₀H₃₆N₂O₂Pt (771.81 g mol⁻¹): C: 62.25; H: 4.70; N: 3.63. Found: C: 62.28; H: 4.79; N: 3.72 %.

Photoluminescence (2% in PMMA matrix): λₘₐₓ = 473 nm, CIE: (0.18;0.26); QY = 82%.

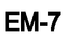

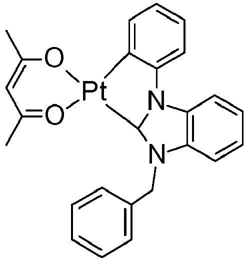

Following the general procedure described above 292 mg of 3-benzyl-1-phenyl-1*H-*benzo[*d*]imidazolium bromide and 0.33 ml of acetylacetone were used to obtain 360 mg (0.62 mmol) of the complex (78%). ¹H-NMR (CDCl₃, 300.13 MHz): δ = 7.94 (dd, *pseudo*-t, *J* = 1.3 Hz, *J* = 7.4 Hz, *J*_{H,Pt}= 28.5 Hz, 1H, PtCCH_{arom.}), 7.93 (d, *J* = 8.1 Hz, 1H, CH_{arom.}), 7.52 (dd, *J* = 1.1 Hz, *J* = 7.9 Hz, 1H, CH_{arom.}), 7.49 (d, *J* = 6.7 Hz, 2H, CH_{arom.}), 7.31 (m, 5H, CH_{arom.}), 7.23 (m, 1H, CH_{arom.}), 7.17 (dt, *J* = 1.4 Hz, *J* = 7.5 Hz, 1H, CH_{arom.}), 7.07 (dt, *J* = 1.4 Hz, *J* = 7.5 Hz, 1H, CH_{arom.}), 6.11 (s, 2H, CH₂), 5.50 (s, 1H, CH), 2.09 (s, 3H, CH₃), 1.78 (s, 3H, CH₃) ppm. ¹³C-NMR (CDCl₃, 125.8 MHz): δ = 185.5 (OCCH₃), 185.4 (OCCH₃), 160.9 (Cᵢ), 148.1 (Cᵢ), 136.1 (Cᵢ), 134.7 (Cᵢ), 131.6 (Cᵢ), 131.3 (C_{arom.}H), 128.6 (C_{arom.}H), 127.6 (C_{arom.}H), 127.5 (C_{arom.}H), 125.5 (Cᵢ), 124.2 (C_{arom.}H), 123.9 (C_{arom.}H), 123.6 (C_{arom.}H), 122.8 (C_{arom.}H), 111.6 (C_{arom.}H), 111.3 (C_{arom.}H), 111.0 (C_{arom.}H), 102.1 (CH), 48.5 (CH₂), 27.9 (CH₃), 27.7 (CH₃) ppm. M.p.: 241-244 °C. Anal. Calc. for C₂₅H₂₂N₂O₂Pt (577.54 g mol⁻¹): C: 51.99; H: 3.84; N: 4.85. Found: C: 52.26; H: 3.71; N: 4.71 %.

Photoluminescence (2% in PMMA matrix): λₘₐₓ = 454 nm, CIE: (0.18;0.20); QY = 53%.

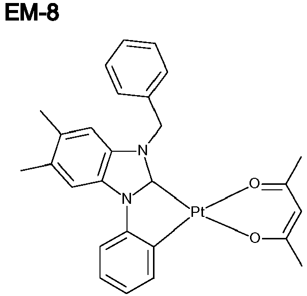

Following the general procedure described above 315 mg of 3-benzyl-5,6-dimethyl-1-phenyl-1*H*-benzo[*d*]imidazolium bromide and 0.33 ml of acetylacetone were used to obtain 319 mg (0.53 mmol) of the complex (66%). ¹H-NMR (CDCl₃, 600.13 MHz): δ = 7.92 (dd, *pseudo*-t, *J* = 1.3 Hz, *J* = 7.4 Hz, *J*_{H,Pt} = 35 Hz, 1H, CH_{arom.}), 7.66 (s, 1H, CH_{arom.}), 7.48 (dd, *J* = 0.8 Hz, *J* = 7.7 Hz, 1H, CH_{arom.}), 7.44 (d, *J* = 7.3 Hz, 2H, CH_{arom.}), 7.28 (t, *J* = 7.5 Hz, 2H, CH_{arom.}), 7.23 (t, *J* = 7.3 Hz, 1H, CH_{arom.}), 7.15 (dt, *J* = 1.3 Hz, *J* = 7.5 Hz, 1H, CH_{arom.}), 7.05 (dt, *J* = 1.3 Hz, *J* = 7.5 Hz, 1H, CH_{arom.}), 7.02 (s, 1H, CH_{arom.}), 6.01 (s, 2H, CH₂), 5.47 (s, 1H, CH), 2.38 (s, 3H, CH₃), 2.27 (s, 3H, CH₃), 2.07 (s, 3H, CH₃), 1.75 (s, 3H, CH₃) ppm. ¹³C-NMR (CDCl₃, 125.8 MHz): δ = 185.3 (OCCH₃), 185.2 (OCCH₃), 159.5 (Cᵢ), 148.3 (Cᵢ), 136.5 (Cᵢ), 133.1 (Cᵢ), 131.8 (Cᵢ), 131.2 (C_{arom.}H), 130.1 (Cᵢ), 128.5 (C_{arom.}H), 127.4 (C_{arom.}H), 127.3 (C_{arom.}H), 125.5 (Cᵢ), 123.7 (C_{arom.}H), 123.3 (C_{arom.}H), 111.6 (C_{arom.}H), 111.5 (C_{arom.}H), 111.4 (C_{arom.}H), 102.0 (CH), 48.3 (CH₂), 27.8 (CH₃), 27.7 (CH₃), 20.4 (CH₃), 20.3 (CH₃) ppm. M.p.: 301-303 °C. Anal. Calc. for C₂₇H₂₆N₂O₂Pt (605.59 g mol⁻¹): C: 53.55; H: 4.33; N: 4.63. Found: C: 53.51; H: 4.50; N: 4.58 %.

Photoluminescence (2% in PMMA matrix): λₘₐₓ = 457 nm, CIE: (0.17;0.16); QY = 47%.

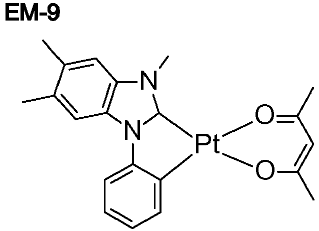

Following the general procedure described above 291 mg of 3,5,6-trimethyl-1-phenyl-1*H-*benzo[*d*]imidazolium iodide and 0.33 ml of acetylacetone were used to obtain 285 mg (0.54 mmol) of the complex (67%). ¹H-NMR (CDCl₃, 600.13 MHz): δ = 8.05 (s, 1H, CH_{arom.}), 7.70 (d, *J* = 7.5 Hz, 1H, CH_{arom.}), 7.68 (dd, *J* = 1.3 Hz, *J* = 7.5 Hz, 1H, CH_{arom.}), 7.50 (s, 1H, CH_{arom.}), 7.10 (dt, *J* = 1.3 Hz, *J* = 7.5 Hz, 1H, CH_{arom.}), 6.93 (dt, *J* = 1.3 Hz, *J* = 7.5 Hz, 1H, CH_{arom.}), 5.64 (s, 1H, CH), 4.23 (s, 3H, NCH₃), 2.43 (s, 3H, CH₃), 2.37 (s, 3H, CH₃), 2.03 (s, 3H, CH₃), 2.01 (s, 3H, CH₃) ppm. M.p.: 261-263 °C. Anal. Calc. for C₂₁H₂₂N₂O₂Pt (529.50 g mol⁻¹): C: 47.64; H: 4.19; N: 5.29. Found: C: 47.26; H: 4.06; N: 5.21 %.

Photoluminescence (2% in PMMA matrix): λₘₐₓ = 455 nm, CIE: (0.18;0.18); QY = 31%.

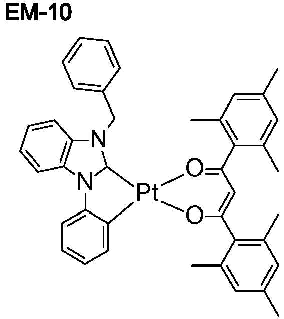

Following the general procedure described above 292 mg of 3-benzyl-1-phenyl-1*H-*benzo[*d*]imidazolium bromide and 987 mg of dimesitoylmethane were used to obtain 399 mg (0.51 mmol) of the complex (64%). ¹H-NMR (CDCl₃, 600.13 MHz): δ = 7.99 (d, *J* = 8.2 Hz, 1H, CH_{arom.}), 7.87 (dd, *J* = 1.3 Hz, *J* = 7.5 Hz, 1H, CH_{arom.}), 7.56 (dd, *J* = 0.8 Hz, *J* = 7.8 Hz, 1H, CH_{arom.}), 7.36 (t, *J* = 7.7 Hz, 1H, CH_{arom.}), 7.29 (d, *J* = 7.7 Hz, 1H, CH_{arom.}), 7.24 (t, *J* = 7.7 Hz, 1H, CH_{arom.}), 7.16 (m, 4H, CH_{arom.}), 7.08 (dd, *J* = 1.4 Hz, *J* = 7.9 Hz, 2H, CH_{arom.}), 6.99 (dt, *J* = 1.3 Hz, *J* = 7.5 Hz, 1H, CH_{arom.}), 6.87 (s, 2H, CH_{arom.}), 6.74 (s, 2H, CH_{arom.}), 5.99 (s, 2H, CH₂), 5.68 (s, 1H, CH), 2.36 (s, 6H, CH₃), 2.31 (s, 3H, CH₃), 2.27 (s, 3H, CH₃), 2.06 (s, 6H, CH₃) ppm. ¹³C-NMR (CDCl₃, 125.8 MHz): δ = 185.7 (OCC), 184.8 (OCC), 160.8 (Cᵢ), 148.1 (Cᵢ), 139.4 (Cᵢ), 139.1 (Cᵢ), 137.7 (Cᵢ), 137.2 (Cᵢ), 136.1 (Cᵢ), 134.9 (Cᵢ), 134.2 (Cᵢ), 133.5 (Cᵢ), 131.8 (CH_{arom.}), 131.5 (Cᵢ), 128.4 (CH_{arom.}), 128.2 (CH_{arom.}), 127.8 (CH_{arom.}), 127.2 (CH_{arom.}), 126.6 (CH_{arom.}), 125.1 (Cᵢ), 124.3 (CH_{arom.}), 124.1 (CH_{arom.}), 123.7 (CH_{arom.}), 123.0 (CH_{arom.}), 111.7 (CH_{arom.}), 111.4 (CH_{arom.}), 111.0 (CH_{arom.}), 107.0 (CH), 48.1 (CH₂), 21.2 (CH₃), 21.1 (CH₃), 20.0 (CH₃), 19.1 (CH₃) ppm. M.p.: 144-145 °C. Anal. Calc. for C₄₁H₃₈N₂O₂Pt (785.85 g mol⁻¹): C: 62.67; H: 4.87; N: 3.56. Found: C: 62.66; H: 4.70; N: 3.60 %.

Photoluminescence (2% in PMMA matrix): λₘₐₓ = 476 nm, CIE: (0.18;0.27); QY = 85%.

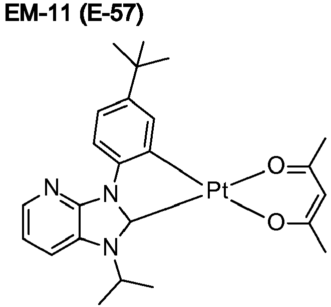

Following the general procedure described above 423 mg of 1-((4-*tert*butyl)phenyl)-3-isopropyl-1*H-*(azabenzo)[*d*]imidazolium iodide and 0.33 ml of acetylacetone were used to obtain 42 mg (0.07 mmol) of the complex (10%). ¹H-NMR (CD₂Cl₂, 400 MHz MHz): δ = 8.42 (d, *J* = 5.9 Hz, 1H), 8.18 (d, *J* = 8.4 Hz, 1H), 7.93 (d, *J* = 8.2 Hz, 1H), 7.86 (s, 1H), 7.21-7.26 (m, 1H), 7.14-7.18 (m, 1H), 6.37 (sept, *J* = 7.2 Hz, 1H), 5.59 (s, 1H), 2.10 (s, 3H), 2.02 (s, 3H), 1.70 (d, *J* = 7.0 Hz, 6H) ppm.

Photoluminescence (2% in PMMA matrix): λₘₐₓ = 465 nm, CIE: (0.16;0.17); QY = 46%.

### Dependency of CIE color coordinates and photoluminescence quantum efficiency (PLQE) from doping concentration

Films of EM-6 in PMMA with varying concentrations of **EM-6** are prepared to evaluate the color and PLQE stability at different concentrations.

| **Amount of EM-6 in EML [%]** | 1 | 3 | 6 | 10 |
|---|---|---|---|---|
| **CIE (x;y)** | 0.18; 0.26 | 0.18; 0.27 | 0.18; 0.29 | 0.19; 0.30 |
| **PLQE [%]** | 82 | 86 | 83 | 83 |

This experiment clearly demonstrates the low sensitivity of CIE color coordinates and PLQE towards a variation of the concentration of the inventive emissive compounds.

### Application Example 1

The ITO substrate used as the anode is cleaned first with commercial detergents for LCD production (Deconex® 20NS, and 25ORGAN-ACID® neutralizing agent) and then in an acetone/isopropanol mixture in an ultrasound bath. To eliminate possible organic residues, the substrate is exposed to a continuous ozone flow in an ozone oven for a further 25 minutes. This treatment also improves the hole injection properties of the ITO. Next, the hole injection layer AJ20-1000 from Plexcore is spun on from solution.

Thereafter, the organic materials specified below are applied by vapor deposition to the cleaned substrate at about 10⁻⁷-10⁻⁹ mbar at a rate of approx. 0.5-5 nm/min. The hole conductor and exciton blocker applied to the substrate is 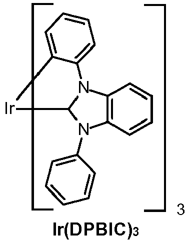 (for preparation of Ir(DPBIC)₃ see Ir complex (7) in the application WO2005/19373) with a thickness of 20 nm, of which the first 10 nm are doped with MoOₓ to improve the conductivity.

Subsequently, a mixture of emitter **Em6** (30 % by wt.), **Ir(DPBIC)₃** (10% by wt.), and compound 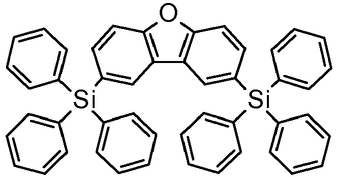 (**Ma1**; 60 % by wt.; compound "4g" in WO2009/003898) is applied by vapor deposition with a thickness of 40 nm, the latter compounds functioning as matrix materials.

Subsequently, the material **Ma1** is applied by vapor deposition with a thickness of 5 nm as a hole blocker. Next, as an electron transporting layer, a mixture of Cs₂CO₃ (5 % by wt.) and BCP (2,9-dimethyl-4,7-diphenyl-1,10-phenanthroline; 95 % by wt.) is applied by vapor deposition with a thickness of 25 nm and finally a 100 nm-thick Al electrode. All components are adhesive-bonded to a glass lid in an inert nitrogen atmosphere.

### Application Example 1

λₘₐₓ = 504 nm, CIE: (0.20; 0.31) ; U = 6.9 V; EQE (external quantum efficiency is # of generated photons escaped from a substance or a device / # of electrons flowing through it): = 12.6%.

### Dependency of CIE color coordinates from doping concentration

Devices according to application example 1 were fabricated with varying emitter concentrations in the emissive layer:
HIL Plexcore AJ20-1000 - 10nm **Ir(DPBIC)₃**:MoOₓ (90:10) - 10nm **Ir(DPBIC)₃** - 40nm **Em6**: **Ma1** (X:(100-X)) - 5nm **Ma1** - 25nm BCP:Cs₂CO₃ (95:5) - 100nm Al.

By varying the doping concentration of **Em6** from 5% to 30% the influence on the color coordinates of the emitted light was determined.

| Amount of EM-6 in EML [%] | 5 | 10 | 20 | 30 |
|---|---|---|---|---|
| CIE (x;y) | 0.19;0.28 | 0.19;0.29 | 0.20;0.31 | 0.20;0.32 |

As these results clearly demonstrate there is only a minor shift in color coordinates when significantly altering the doping concentration in a range from 5% to 30%. This low concentration dependency is especially important for reproducibility in mass production.

## Claims

1. A metal-carbene complex of the general formula 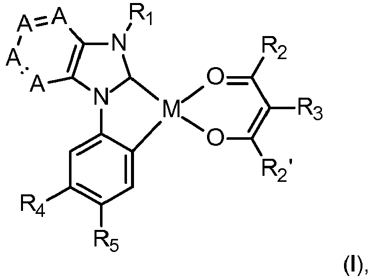 wherein
M is Pd or Pt,
R₁ is a linear or branched alkyl radical optionally interrupted by at least one heteroatom, optionally bearing at least one functional group selected from the group consisting of C₁-C₂₀-alkyl, C₁-C₂₀-alkoxy, halogen, C₁-C₂₀-haloalkyl, and C₆-C₃₀-aryl, and having 1 to 20 carbon atoms, a cycloalkyl radical optionally interrupted by at least one heteroatom, and having 3 to 20 carbon atoms and wherein the cycloalkyl radical is optionally substituted with at least one group selected from the group consisting of C₁-C₂₀-alkyl, C₁-C₂₀-alkoxy, halogen, C₁-C₂₀-haloalkyl, and C₆-C₃₀-aryl, an aryl radical having 6 to 30 carbon atoms and wherein the aryl radical is optionally substituted with at least one group selected from the group consisting of C₁-C₂₀-alkyl, C₆-C₃₀-aryl and a group with donor or acceptor action, a heteroaryl radical having a total of 5 to 18 carbon atoms and/or heteroatoms selected from N, O and S and wherein the heteroaryl radical is optionally substituted with at least one group selected from the group consisting of C₁-C₂₀-alkyl, C₆-C₃₀-aryl and a group with donor or acceptor action,
R₂ and R₂' are independently of each other a linear or branched alkyl radical having 1 to 6 carbons atoms, a cycloalkyl radical having 3 to 20 carbon atoms optionally substituted with at least one group selected from the group consisting of C₁-C₂₀-alkyl, C₁-C₂₀-alkoxy, halogen, C₁-C₂₀-haloalkyl, and C₆-C₃₀-aryl, an aryl radical having 6 to 20 carbon atoms optionally substituted with at least one group selected from the group consisting of C₁-C₂₀-alkyl, C₆-C₃₀-aryl and a group with donor or acceptor action, or a heteroaryl radical having a total of 5 to 18 carbon atoms and/or heteroatoms selected from N, O and S optionally substituted with at least one group selected from the group consisting of C₁-C₂₀-alkyl, C₆-C₃₀-aryl and a group with donor or acceptor action,
R₃ is hydrogen, a linear or branched alkyl radical having 1 to 6 carbon atoms, or an aryl radical having 6 to 20 carbon atoms optionally substituted with at least one group selected from the group consisting of C₁-C₂₀-alkyl, C₆-C₃₀-aryl and a group with donor or acceptor action,
R₄ and R₅ are independently of each other hydrogen, a linear or branched alkyl radical optionally interrupted by at least one heteroatom, and having 1 to 6 carbon atoms, cycloalkyl radical optionally interrupted by at least one heteroatom, and having 3 to 12 carbon atoms and wherein the cycloalkyl radical is optionally substituted with at least one group selected from the group consisting of C₁-C₂₀-alkyl, C₁-C₂₀-alkoxy, halogen, C₁-C₂₀-haloalkyl, and C₆-C₃₀-aryl, an aryl radical optionally interrupted by at least one heteroatom, and having 6 to 15 carbon atoms and wherein the aryl radical is optionally substituted with at least one group selected from the group consisting of C₁-C₂₀-alkyl, C₆-C₃₀-aryl and a group with donor or acceptor action, a heteroaryl radical having a total of 5 to 18 carbon atoms and/or heteroatoms selected from N, O and S and wherein the heteroaryl radical is optionally substituted with at least one group selected from the group consisting of C₁-C₂₀-alkyl, C₆-C₃₀-aryl and a group with donor or acceptor action, group with donor or acceptor action,
A is independently in each occurrence CR₆ or N, with the proviso that at least 3 A's are CR₆;
each R₆ is independently of each other hydrogen, a linear or branched alkyl radical optionally interrupted by at least one heteroatom, and having 1 to 20 carbon atoms, a cycloalkyl radical optionally interrupted by at least one heteroatom, and having 3 to 20 carbon atoms and wherein the cycloalkyl radical is optionally substituted with at least one group selected from the group consisting of C₁-C₂₀-alkyl, C₁-C₂₀-alkoxy, halogen, C₁-C₂₀-haloalkyl, and C₆-C₃₀-aryl, an aryl radical optionally interrupted by at least one heteroatom, and having 6 to 30 carbon atoms and wherein the aryl radical is optionally substituted with at least one group selected from the group consisting of C₁-C₂₀-alkyl, C₆-C₃₀-aryl and a group with donor or acceptor action, a heteroaryl radical having a total of 5 to 18 carbon atoms and/or heteroatoms selected from N, O and S and wherein the heteroaryl radical is optionally substituted with at least one group selected from the group consisting of C₁-C₂₀-alkyl, C₆-C₃₀-aryl and a group with donor or acceptor action, group with donor or acceptor action, whereby the group with donor or acceptor action is selected from the group consisting of: C₁- to C₂₀-alkoxy; C₆-C₃₀-aryloxy; SiR⁶⁴R⁶⁵R⁶⁶, where R⁶⁴, R⁶⁵ and R⁶⁶ are each independently alkyl or phenyl; halogen radicals; halogenated C₁-C₂₀-alkyl radicals; amino; OH; and -C(O)OC₁-C₄-alkyl.

2. The metal-carbene complex according to claim 1 of the general formula 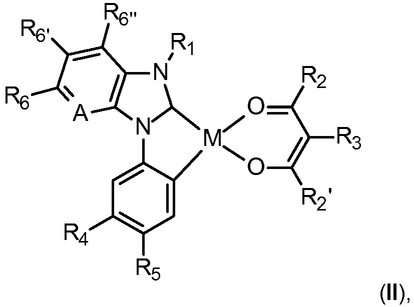 wherein
R_{6'} and R_{6"} have independently of each other the meaning of R₆ and
M, R₁, R₂, R₂', R₃, R₄, R₅, R₆ and A are each defined as in claim 1.

3. The metal-carbene complex according to claim 2 of the general formula 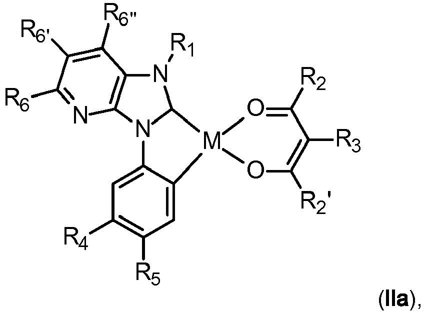 or 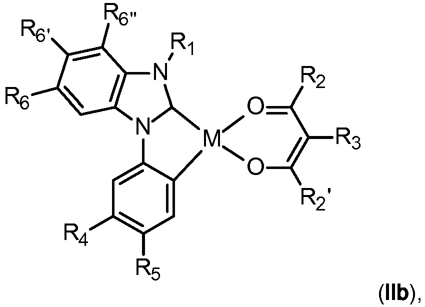 wherein M, R₁, R₂, R₂', R₃, R₄, R₅, R₆, R_{6'}, R_{6"} and A are each defined as in claim 2.

4. The metal-carbene complex according to any of claims 1 to 3, wherein M is Pt.

5. The metal-carbene complex according to any of claims 1 to 4, wherein R₃ is hydrogen, a linear or branched alkyl radical having 1 to 6 carbon atoms.

6. The metal-carbene complex according to any of claims 1 to 5, wherein
R₂ and R₂' are independently of each other a linear or branched alkyl radical having 1 to 6 carbon atoms, an aryl radical having 6 to 20 carbon atoms optionally substituted with at least one group selected from the group consisting of C₁-C₂₀-alkyl, C₆-C₃₀-aryl and a group with donor or acceptor action, a heteroaryl radical having a total of 5 to 18 carbon atoms and/or heteroatoms selected from N, O and S optionally substituted with at least one group selected from the group consisting of C₁-C₂₀-alkyl, C₆-C₃₀-aryl and a group with donor or acceptor action.

7. The metal-carbene complex according to any of claims 1 to 6, wherein R₄ and R₅ are each independently hydrogen, a linear or branched alkyl radical having 1 to 6 carbon atoms, an aryl radical having 6 to 15 carbon atoms optionally substituted with at least one group selected from the group consisting of C₁-C₂₀-alkyl, C₆-C₃₀-aryl and a group with donor or acceptor action, or a group with donor or acceptor action, selected from halogen radicals.

8. The metal-carbene complex according to any of claims 1 to 6, wherein R₁ is a linear or branched alkyl radical having 1 to 6 carbons atoms, or unsubstituted aryl radical having 6 to 15 carbon atoms.

9. The metal-carbene complex according to any of claims 1 to 8, wherein R₆ and R_{6'} are hydrogen, or C₁-C₆alkyl; and R_{6"} is hydrogen.

10. An organic electronic device, comprising at least one metal-carbene complex according to any of claims 1 to 9.

11. The organic electronic device according to claim 10, wherein the organic electronic device is selected from organic light-emitting diodes (OLEDs), organic photovoltaic cells (OPVs), organic field-effect transistors (OFETs) and light-emitting electrochemical cells (LEECs).

12. A light-emitting layer comprising at least one metal-carbene complex according to any of claims 1 to 9.

13. The light-emitting layer according to claim 12, comprising at least one metal-carbene complex according to any of claims 1 to 9 and a host material.

14. An apparatus selected from the group consisting of stationary visual display units such as visual display units of computers, televisions, visual display units in printers, kitchen appliances and advertising panels, illuminations, information panels, and mobile visual display units such as visual display units in cellphones, tablet PCs, laptops, digital cameras, MP3 players, vehicles and destination displays on buses and trains; illumination units; keyboards; items of clothing; furniture; wallpaper, comprising the organic electronic device according to claim 10, or 11, or the emitting layer according to claim 12, or 13.

15. Use of metal-carbene complex according to any of claims 1 to 9 for electrophotographic photoreceptors, photoelectric converters, organic solar cells (organic photovoltaics), switching elements, organic light emitting field effect transistors (OLEFETs), image sensors, dye lasers and electroluminescent devices.

16. A process for preparing the metal-carbene complexes according to claim 1 by contacting suitable compounds comprising M with compounds of the general formula 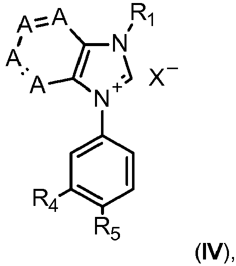 wherein
R₁, R₄, R₅ and A are each as defined in claim 1 and
X is F, Cl, Br, I, PF₆, or BF₄.

## Patentansprüche

1. Ein Metall-Carben-Komplex der allgemeinen Formel 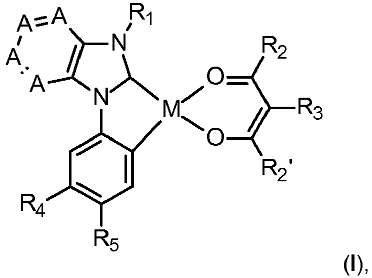 wobei M Pd oder Pt ist,
R₁ ein linearer oder verzweigter Alkylrest, der optional durch mindestens ein Heteroatom unterbrochen ist, der optional mindestens eine funktionelle Gruppe trägt ausgewählt aus der Gruppe bestehend aus C₁-C₂₀-Alkyl, C₁-C₂₀-Alkoxy, Halogen, C₁-C₂₀-Halogenalkyl und C₆-C₃₀-Aryl, und 1 bis 20 Kohlenstoffatome aufweist, ein Cycloalkylrest, der optional durch mindestens ein Heteroatom unterbrochen ist und 3 bis 20 Kohlenstoffatome aufweist, und wobei der Cycloalkylrest optional mit mindestens einer Gruppe substituiert ist ausgewählt aus der Gruppe bestehend aus C₁-C₂₀-Alkyl, C₁-C₂₀-Alkoxy, Halogen, C₁-C₂₀-Halogenalkyl und C₆-C₃₀-Aryl, ein Arylrest mit 6 bis 30 Kohlenstoffatomen und wobei der Arylrest optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, ein Heteroarylrest mit insgesamt 5 bis 18 Kohlenstoffatomen und/oder Heteroatomen ausgewählt aus N, O und S, und wobei der Heteroarylrest optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, ist,
R₂ und R₂' unabhängig voneinander ein linearer oder verzweigter Alkylrest mit 1 bis 6 Kohlenstoffatomen, ein Cycloalkylrest mit 3 bis 20 Kohlenstoffatomen, der optional mit mindestens einer Gruppe substituiert ist ausgewählt aus der Gruppe bestehend aus C₁-C₂₀-Alkyl, C₁-C₂₀-Alkoxy, Halogen, C₁-C₂₀-Halogenalkyl und C₆-C₃₀-Aryl, ein Arylrest mit 6 bis 20 Kohlenstoffatomen, der optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, oder ein Heteroarylrest mit insgesamt 5 bis 18 Kohlenstoffatomen und/oder Heteroatomen ausgewählt aus N, O und S, der optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, sind,
R₃ Wasserstoff, ein linearer oder verzweigter Alkylrest mit 1 bis 6 Kohlenstoffatomen oder ein Arylrest mit 6 bis 20 Kohlenstoffatomen, der optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, ist,
R₄ und R₅ unabhängig voneinander Wasserstoff, ein linearer oder verzweigter Alkylrest, der optional durch mindestens ein Heteroatom unterbrochen ist, und 1 bis 6 Kohlenstoffatome aufweist, ein Cycloalkylrest, der optional durch mindestens ein Heteroatom unterbrochen ist, und 3 bis 12 Kohlenstoffatome aufweist, und wobei der Cycloalkylrest optional durch mindestens eine Gruppe substituiert ist ausgewählt aus der Gruppe bestehend aus C₁-C₂₀-Alkyl, C₁-C₂₀-Alkoxy, Halogen, C₁-C₂₀-Halogenalkyl und C₆-C₃₀-Aryl, ein Arylrest, der optional durch mindestens ein Heteroatom unterbrochen ist, und 6 bis 15 Kohlenstoffatome aufweist und wobei der Arylrest optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, ein Heteroarylrest mit insgesamt 5 bis 18 Kohlenstoffatomen und/oder Heteroatomen ausgewählt aus N, O und S, und wobei der Heteroarylrest optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, eine Gruppe mit Donor- oder Akzeptorwirkung, sind,
A unabhängig bei jedem Auftreten CR₆ oder N ist, mit der Maßgabe, dass mindestens 3 A CR₆ sind,
jedes R₆ unabhängig voneinander Wasserstoff, ein linearer oder verzweigter Alkylrest, der optional durch mindestens ein Heteroatom unterbrochen ist, und 1 bis 20 Kohlenstoffatome aufweist, ein Cycloalkylrest, der optional durch mindestens ein Heteroatom unterbrochen ist, und 3 bis 20 Kohlenstoffatome aufweist und wobei der Cycloalkylrest optional mit mindestens einer Gruppe substituiert ist ausgewählt aus der Gruppe bestehend aus C₁-C₂₀-Alkyl, C₁-C₂₀-Alkoxy, Halogen, C₁-C₂₀-Halogenalkyl und C₆-C₃₀-Aryl, ein Arylrest, der optional durch mindestens ein Heteroatom unterbrochen ist, und 6 bis 30 Kohlenstoffatome aufweist und wobei der Arylrest optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, ein Heteroarylrest mit insgesamt 5 bis 18 Kohlenstoffatomen und/oder Heteroatomen ausgewählt aus N, O und S und wobei der Heteroarylrest optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, Gruppe mit Donor- oder Akzeptorwirkung, wobei die Gruppe mit Donor- oder Akzeptorwirkung ausgewählt ist aus der Gruppe bestehend aus: C₁- bis C₂₀-Alkoxy; C₆-C₃₀-Aryloxy; SiR⁶⁴R⁶⁵R⁶⁶, wobei R⁶⁴, R⁶⁵ und R⁶⁶ jeweils unabhängig voneinander Alkyl oder Phenyl sind; Halogenreste; halogenierte C₁-C₂₀-Alkylreste; Amino; OH; und -C(O)OC₁-C₄-Alkyl, ist.

2. Der Metall-Carben-Komplex nach Anspruch 1 der allgemeinen Formel 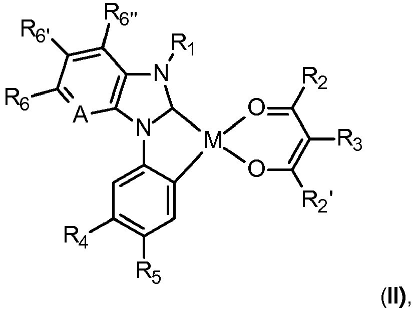 wobei
R_{6'} und R_{6"} unabhängig voneinander die Bedeutung von R₆ haben und
M, R₁, R₂, R₂', R₃, R₄, R₅, R₆ und A jeweils wie in Anspruch 1 definiert sind.

3. Der Metall-Carben-Komplex nach Anspruch 2 der allgemeinen Formel 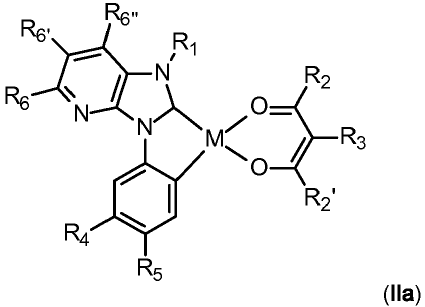 oder 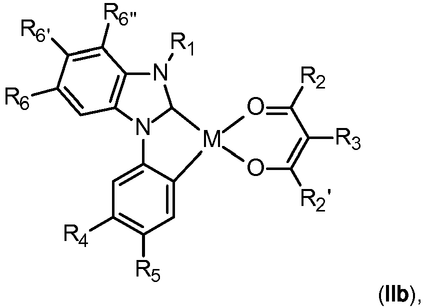 wobei M, R₁, R₂, R₂', R₃, R₄, R₅, R₆, R_{6'}, R_{6"} und A jeweils wie in Anspruch 2 definiert sind.

4. Der Metall-Carben-Komplex nach einem der Ansprüche 1 bis 3, wobei M Pt ist.

5. Der Metall-Carben-Komplex nach einem der Ansprüche 1 bis 4, wobei R₃ Wasserstoff, ein linearer oder verzweigter Alkylrest mit 1 bis 6 Kohlenstoffatomen ist.

6. Der Metall-Carben-Komplex nach einem der Ansprüche 1 bis 5, wobei R₂ und R₂' unabhängig voneinander ein linearer oder verzweigter Alkylrest mit 1 bis 6 Kohlenstoffatomen, ein Arylrest mit 6 bis 20 Kohlenstoffatomen, der optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, ein Heteroarylrest mit insgesamt 5 bis 18 Kohlenstoffatomen und/oder Heteroatomen ausgewählt aus N, O und S, der optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, sind.

7. Der Metall-Carben-Komplex nach einem der Ansprüche 1 bis 6, wobei R₄ und R₅ jeweils unabhängig voneinander Wasserstoff, ein linearer oder verzweigter Alkylrest mit 1 bis 6 Kohlenstoffatomen, ein Arylrest mit 6 bis 15 Kohlenstoffatomen, der optional mit mindestens einer Gruppe substituiert ist ausgewählt aus der Gruppe bestehend aus C₁-C₂₀-Alkyl, C₆-C₃₀-Aryl und einer Gruppe mit Donor- oder Akzeptorwirkung, oder einer Gruppe mit Donor- oder Akzeptorwirkung ausgewählt aus Halogenresten, sind.

8. Der Metall-Carben-Komplex nach einem der Ansprüche 1 bis 6, wobei R₁ ein linearer oder verzweigter Alkylrest mit 1 bis 6 Kohlenstoffatomen oder ein unsubstituierter Arylrest mit 6 bis 15 Kohlenstoffatomen ist.

9. Der Metall-Carben-Komplex nach einem der Ansprüche 1 bis 8, wobei R₆ und R_{6'} Wasserstoff oder C₁-C₆-Alkyl sind und R_{6"} Wasserstoff ist.

10. Eine organische elektronische Vorrichtung umfassend mindestens einen Metall-Carben-Komplex nach einem der Ansprüche 1 bis 9.

11. Die organische elektronische Vorrichtung nach Anspruch 10, wobei die organische elektronische Vorrichtung ausgewählt ist aus organischen lichtemittierenden Dioden (OLEDs), organischen Photovoltaikzellen (OPVs), organischen Feldeffekttransistoren (OFETs) und lichtemittierenden elektrochemischen Zellen (LEECs).

12. Eine lichtemittierende Schicht umfassend mindestens einen Metall-Carben-Komplex nach einem der Ansprüche 1 bis 9.

13. Die lichtemittierende Schicht nach Anspruch 12 umfassend mindestens einen Metall-Carben-Komplex nach einem der Ansprüche 1 bis 9 und ein Wirtsmaterial.

14. Eine Vorrichtung ausgewählt aus der Gruppe bestehend aus stationären visuellen Anzeigeeinheiten wie visuellen Anzeigeeinheiten von Computern, Fernsehern, visuellen Anzeigeeinheiten in Druckern, Küchengeräten und Werbetafeln, Beleuchtungen, Informationstafeln und mobilen visuellen Anzeigeeinheiten wie visuellen Anzeigeeinheiten in Handys, Tablet-PCs, Laptops, Digitalkameras, MP3-Playern, Fahrzeugen und Zielanzeigen in Bussen und Bahnen; Beleuchtungseinheiten; Tastaturen; Kleidungsstücken; Möbel; Tapeten, umfassend die organische elektronische Vorrichtung nach Anspruch 10 oder 11 oder die emittierende Schicht nach Anspruch 12 oder 13.

15. Verwendung von Metall-Carben-Komplex nach einem der Ansprüche 1 bis 9 für elektrofotografische Photorezeptoren, photoelektrische Wandler, organische Solarzellen (organische Photovoltaik), Schaltelemente, organische lichtemittierende Feldeffekttransistoren (OLEFETs), Bildsensoren, Farbstofflaser und elektrolumineszierende Vorrichtungen.

16. Ein Verfahren zur Herstellung der Metall-Carben-Komplexe nach Anspruch 1 durch Inkontaktbringen geeigneter Verbindungen, umfassend M, mit Verbindungen der allgemeinen Formel 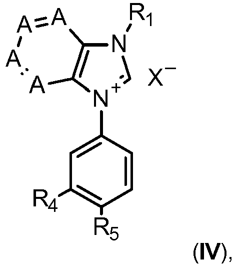 wobei
R₁, R₄, R₅ und A jeweils wie in Anspruch 1 definiert sind und
X F, Cl, Br, I, PF₆ oder BF₄ ist.

## Revendications

1. Complexe métal-carbène de la formule générale 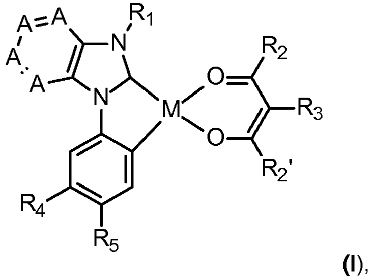 où
M est Pd ou Pt,
R₁ est un radical alkyle linéaire ou ramifié facultativement interrompu par au moins un hétéroatome, portant facultativement au moins un groupe fonctionnel choisi dans le groupe constitué par alkyle en C₁-C₂₀, alcoxy en C₁-C₂₀, halogène, haloalkyle en C₁-C₂₀, et aryle en C₆-C₃₀, et ayant 1 à 20 atomes de carbone, un radical cycloalkyle facultativement interrompu par au moins un hétéroatome, et ayant 3 à 20 atomes de carbone et où le radical cycloalkyle est facultativement substitué par au moins un groupe choisi dans le groupe constitué par alkyle en C₁-C₂₀, alcoxy en C₁-C₂₀ halogène, haloalkyle en C₁-C₂₀, et aryle en C₆-C₃₀, un radical aryle ayant 6 à 30 atomes de carbone et où le radical aryle est facultativement substitué par au moins un groupe choisi dans le groupe constitué par alkyle en C₁-C₂₀, aryle en C₆-C₃₀ et un groupe avec une action donneur ou accepteur, un radical hétéroaryle ayant un total de 5 à 18 atomes de carbone et/ou hétéroatomes choisis parmi N, O et S et où le radical hétéroaryle est facultativement substitué par au moins un groupe choisi dans le groupe constitué par alkyle en C₁-C₂₀, aryle en C₆-C₃₀ et un groupe avec une action donneur ou accepteur,
R₂ et R₂' sont indépendamment l'un de l'autre un radical alkyle linéaire ou ramifié ayant 1 à 6 atomes de carbone, un radical cycloalkyle ayant 3 à 20 atomes de carbone facultativement substitué par au moins un groupe choisi dans le groupe constitué par alkyle en C₁-C₂₀, alcoxy en C₁-C₂₀, halogène, haloalkyle en C₁-C₂₀, et aryle en C₆-C₃₀, un radical aryle ayant 6 à 20 atomes de carbone facultativement substitué par au moins un groupe choisi dans le groupe constitué par alkyle en C₁-C₂₀, aryle en C₆-C₃₀ et un groupe avec une donneur ou accepteur, ou un radical hétéroaryle ayant un total de 5 à 18 atomes de carbone et/ou hétéroatomes choisis parmi N, O et S facultativement substitué par au moins un groupe choisi dans le groupe constitué par alkyle en C₁-C₂₀, aryle en C₆-C₃₀ et un groupe avec une action donneur ou accepteur, R₃ est l'hydrogène, un radical alkyle linéaire ou ramifié ayant 1 à 6 atomes de carbone, ou un radical aryle ayant 6 à 20 atomes de carbone facultativement substitué par au moins un groupe choisi dans le groupe constitué par alkyle en C₁-C₂₀, aryle en C₆-C₃₀ et un groupe avec une action donneur ou accepteur,
R₄ et R₅ sont indépendamment l'un de l'autre l'hydrogène, un radical alkyle linéaire ou ramifié facultativement interrompu par au moins un hétéroatome, et ayant 1 à 6 atomes de carbone, un radical cycloalkyle facultativement interrompu par au moins un hétéroatome, et ayant 3 à 12 atomes de carbone et où le radical cycloalkyle est facultativement substitué par au moins un groupe choisi dans le groupe constitué par alkyle en C₁-C₂₀, alcoxy en C₁-C₂₀, halogène, et aryle en C₆-C₃₀, un radical aryle facultativement interrompu par au moins un hétéroatome, et ayant de 6 à 15 atomes de carbone et où le radical aryle est facultativement substitué par au moins un groupe choisi dans le groupe constitué par alkyle en C₁-C₂₀, aryle en C₆-C₃₀ et un groupe avec une action donneur ou accepteur, un radical hétéroaryle ayant un total de 5 à 18 atomes de carbone et/ou hétéroatomes choisis parmi N, O et S et où le radical hétéroaryle est facultativement substitué par au moins un groupe choisi dans le groupe constitué par alkyle en C₁-C₂₀, aryle en C₆-C₃₀ et un groupe avec une action donneur ou accepteur, un groupe avec une action donneur ou accepteur,
A est indépendamment dans chaque occurrence CR₆ ou N, à la condition qu'au moins 3 A soient CR₆ ;
chaque R₆ est indépendamment des autres l'hydrogène, un radical alkyle linéaire ou ramifié facultativement interrompu par au moins un hétéroatome, et ayant 1 à 20 atomes de carbone, un radical cycloalkyle facultativement interrompu par au moins un hétéroatome, et ayant 3 à 20 atomes de carbone et où le radical cycloalkyle est facultativement substitué par au moins un groupe choisi dans le groupe constitué par alkyle en C₁-C₂₀, alcoxy en C₁-C₂₀, halogène, haloalkyle en C₁-C₂₀, et aryle en C₆-C₃₀, un radical aryle facultativement interrompu par au moins un hétéroatome, et ayant 6 à 30 atomes de carbone et où le radical aryle est facultativement substitué par au moins un groupe choisi dans le groupe constitué par alkyle en C₁-C₂₀, aryle en C₆-C₃₀ et un groupe avec une action donneur ou accepteur, un radical hétéroaryle ayant un total de 5 à 18 atomes de carbone et/ou hétéroatomes choisis parmi N, O et S et où le radical hétéroaryle est facultativement substitué par au moins un groupe choisi dans le groupe constitué par alkyle en C₁-C₂₀, aryle en C₆-C₃₀ et un groupe avec une action donneur ou accepteur, un groupe avec une action donneur ou accepteur, où le groupe à action donneur ou accepteur est choisi dans le groupe constitué par : alcoxy en C₁ à C₂₀ ; aryloxy en C₆-C₃₀ ; SiR⁶⁴R⁶⁵R⁶⁶, où R⁶⁴, R⁶⁵ et R⁶⁶ sont chacun indépendamment alkyle ou phényle ; des radicaux halogène ; des radicaux alkyle en C₁-C₂₀ halogénés ; amino ; OH ; et -C(O)O-alkyle en C₁-C₄.

2. Complexe métal-carbène selon la revendication 1 de la formule générale 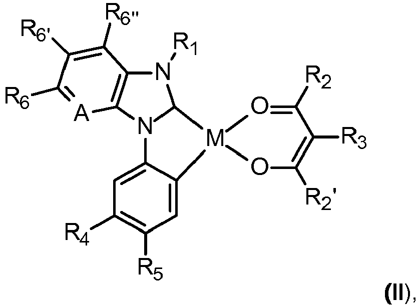 où
R_{6'} et R_{6"} ont indépendamment l'un de l'autre la signification de R₆ et
M, R₁, R₂, R₂', R₃, R₄, R₅, R₆ et A sont chacun définis tels que dans la revendication 1.

3. Complexe métal-carbène selon la revendication 2 de la formule générale 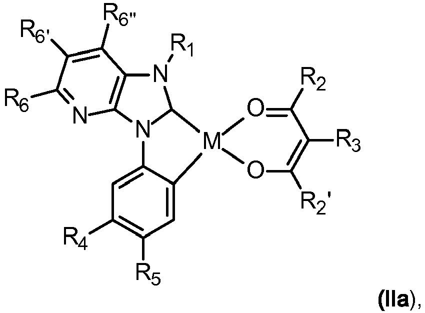 ou 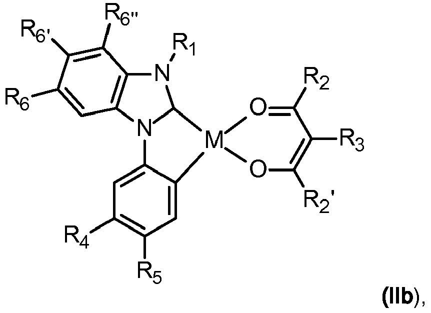 où M, R₁, R₂, R₂', R₃, R₄, R₅, R₆, R_{6'}, R_{6"} et A sont chacun définis tels que dans la revendication 2.

4. Complexe métal-carbène selon l'une quelconque des revendications 1 à 3, où M est Pt.

5. Complexe métal-carbène selon l'une quelconque des revendications 1 à 4, où R₃ est l'hydrogène, un radical alkyle linéaire ou ramifié ayant 1 à 6 atomes de carbone.

6. Complexe métal-carbène selon l'une quelconque des revendications 1 à 5, où R₂ et R₂' sont indépendamment l'un de l'autre un radical alkyle linéaire ou ramifié ayant 1 à 6 atomes de carbone, un radical aryle ayant 6 à 20 atomes de carbone facultativement substitué par au moins un groupe choisi dans le groupe constitué par alkyle en C₁-C₂₀, aryle en C₆-C₃₀ et un groupe avec une donneur ou accepteur, un radical hétéroaryle ayant un total de 5 à 18 atomes de carbone et/ou hétéroatomes choisis parmi N, O et S facultativement substitué par au moins un groupe choisi dans le groupe constitué par alkyle en C₁-C₂₀, aryle en C₆-C₃₀ et un groupe avec une action donneur ou accepteur.

7. Complexe métal-carbène selon l'une quelconque des revendications 1 à 6, où R₄ et R₅ sont chacun indépendamment l'hydrogène, un radical alkyle linéaire ou ramifié ayant 1 à 6 atomes de carbone, un radical aryle ayant 6 à 15 atomes de carbone facultativement substitué par au moins un groupe choisi dans le groupe constitué par alkyle en C₁-C₂₀, aryle en C₆-C₃₀ et un groupe avec une action donneur ou accepteur, ou un groupe avec une action donneur ou accepteur, choisi parmi les radicaux halogène.

8. Complexe métal-carbène selon l'une quelconque des revendications 1 à 6, où R₁ est un radical alkyle linéaire ou ramifié ayant 1 à 6 atomes de carbone, ou un radical aryle non substitué ayant 6 à 15 atomes de carbone.

9. Complexe métal-carbène selon l'une quelconque des revendications 1 à 8, où R₆ et R₆ sont l'hydrogène, ou alkyle en C₁-C₆ ; et R_{6"} est l'hydrogène.

10. Dispositif électronique organique, comprenant au moins un complexe métal-carbène selon l'une quelconque des revendications 1 à 9.

11. Dispositif électronique organique selon la revendication 10, le dispositif électronique organique étant choisi parmi les diodes électroluminescentes organiques (OLED), les cellules photovoltaïques organiques (OPV), les transistors organiques à effet de champ (OFET) et les cellules électrochimiques électroluminescentes (LEEC).

12. Couche électroluminescente comprenant au moins un complexe métal-carbène selon l'une quelconque des revendications 1 à 9.

13. Couche électroluminescente selon la revendication 12, comprenant au moins un complexe métal-carbène selon l'une quelconque des revendications 1 à 9 et un matériau hôte.

14. Appareil choisi dans le groupe constitué par les unités d'affichage visuel stationnaires telles que les unités d'affichage visuel d'ordinateurs, les téléviseurs, les unités d'affichage visuel dans les imprimantes, les appareils de cuisine et les panneaux publicitaires, les éclairages, les panneaux d'information, et les unités d'affichage visuel mobiles telles que les unités d'affichage visuel dans les téléphones cellulaires, les tablettes électroniques, les ordinateurs portables, les appareils photo numériques, les lecteurs MP3, les véhicules et les affichages de destination à bord des autobus et des trains ; les unités d'éclairage ; les claviers ; les articles vestimentaires ; les meubles ; les papiers peints, comprenant le dispositif électronique organique selon la revendication 10 ou 11, ou la couche électroluminescente selon la revendication 12 ou 13.

15. Utilisation d'un complexe métal-carbène selon l'une quelconque des revendications 1 à 9 pour des photorécepteurs électrophotographiques, des convertisseurs photoélectriques, des cellules solaires organiques (photovoltaïques organiques), des éléments de commutation, des transistors organiques électroluminescents à effet de champ (OLEFET), des capteurs d'image, des lasers à colorants et des dispositifs électroluminescents.

16. Procédé pour la préparation des complexes métal-carbène selon la revendication 1 par mise en contact de composés appropriés comprenant M avec des composés de la formule générale 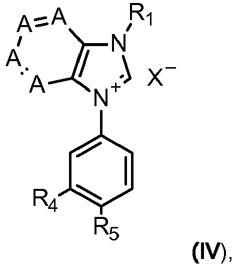 où
R₁, R₄, R₅ et A sont chacun tels que définis dans la revendication 1 et
X est F, Cl, Br, I, PF₆ ou BF₄.
